(19) **Europäisches Patentamt / European Patent Office / Office européen des brevets**

(11) **EP 3 539 125 B1**

(12) **EUROPEAN PATENT SPECIFICATION**

(45) Date of publication and mention of the grant of the patent:
**30.11.2022  Bulletin 2022/48**

(21) Application number: **17791414.0**

(22) Date of filing: **30.10.2017**

(51) International Patent Classification (IPC):
**G10L 19/008** *(2013.01)*

(52) Cooperative Patent Classification (CPC):
**G10L 19/008; H04S 2400/01; H04S 2420/03**

(86) International application number:
**PCT/EP2017/077822**

(87) International publication number:
**WO 2018/086947 (17.05.2018 Gazette 2018/20)**

(54) **APPARATUS AND METHOD FOR ENCODING OR DECODING A MULTICHANNEL SIGNAL USING A SIDE GAIN AND A RESIDUAL GAIN**

**VORRICHTUNG UND VERFAHREN ZUR CODIERUNG ODER DECODIERUNG EINES MEHRKANALSIGNALS MIT SEITLICHER VERSTÄRKUNG UND RESTVERSTÄRKUNG**

**APPAREIL ET PROCÉDÉ POUR LE CODAGE OU LE DÉCODAGE D'UN SIGNAL MULTIVOIE AU MOYEN D'UN GAIN LATÉRAL ET D'UN GAIN RÉSIDUEL**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.11.2016  EP 16197816**

(43) Date of publication of application:
**18.09.2019  Bulletin 2019/38**

(73) Proprietor: **Fraunhofer-Gesellschaft zur Förderung der angewandten Forschung e.V.
80686 München (DE)**

(72) Inventors:
- **BÜTHE, Jan
  91054 Erlangen (DE)**
- **FUCHS, Guillaume
  91088 Bubenreuth (DE)**
- **JÄGERS, Wolfgang
  91056 Erlangen (DE)**
- **REUTELHUBER, Franz
  91056 Erlangen (DE)**
- **HERRE, Jürgen
  91054 Erlangen (DE)**
- **FOTOPOULOU, Eleni
  90409 Nürnberg (DE)**
- **MULTRUS, Markus
  90469 Nürnberg (DE)**
- **KORSE, Srikanth
  90408 Nürnberg (DE)**

(74) Representative: **Zinkler, Franz et al
Schoppe, Zimmermann, Stöckeler Zinkler, Schenk & Partner mbB
Patentanwälte
Radlkoferstrasse 2
81373 München (DE)**

(56) References cited:
**EP-A1- 3 067 889      WO-A2-2019/020757
US-A1- 2006 190 247    US-B2- 8 036 904**

**Description**

The present invention relates to the field of audio encoding and, particularly, to the field of stereo or multichannel encoding/decoding.

The state of the art methods for lossy parametric encoding of stereo signals at low bitrates are based on parametric stereo as standardized in MPEG-4 Part 3. The general idea is to reduce the number of channels by computing a downmix signal from two input channels after extracting stereo parameters which are sent as side information to the decoder. These stereo parameters are usually inter-channel-level-difference ILD, inter-channel-phase-difference IPD, and inter-channel-coherence ICC, which are calculated in subbands and which capture the spatial image to a certain extent.

The decoder performs an upmix of the mono input, creating two channels satisfying the ILD, IPD and ICC relations. This is done by matrixing the input signal together with a decorrelated version of that signal which is generated at the decoder.

It has been found that e.g. the usage of such parameters incurs a significant complexity for calculating and handling these parameters. Particularly, the ILD parameter is problematic, since it can have values that are very small or very big and this almost unrestricted range of values raises problems with respect to an efficient calculation, quantization etc.

US 2006190247 A1 discloses a multi-channel encoder/decoder scheme that generates a waveform-type residual signal. This residual signal is transmitted together with one or more multi-channel parameters to a decoder.

EP 3067889 A1 discloses a decoder for decoding an encoded audio signal. The decoder comprises an adaptive spectrum-time converter and an overlap-add-processor. The adaptive spectrum-time converter converts successive blocks of spectral values into successive blocks of time values. Furthermore, the adaptive spectrum-time converter receives a control information and switches, in response to the control information, between transform kernels of a first group of transform kernels comprising one or more transform kernels having different symmetries at sides of a kernel, and a second group of transform kernels comprising one or more transform kernels having the same symmetries at sides of a transform kernel.

US 8036904 B2 discloses an audio encoder adapted to encode a multi-channel audio signal, the encoder comprising an encoder combination module for generating a dominant signal part and a residual signal part being a combined representation of first and second audio signals, the dominant and residual signal parts being obtained by applying a mathematical procedure to the first and second audio signals, wherein the mathematical procedure involves a first spatial parameter comprising a description of spatial properties of the first and second audio signals, a parameter generator for generating a first parameter set comprising a second spatial parameter, and a second parameter set comprising a third spatial parameter, and an output generator for generating an encoded output signal comprising a first output comprising the dominant signal part and the first parameter set, and a second output part comprising the residual signal part and the second parameter set. The mathematical procedure includes a two-dimensional signal rotation, and the third spatial parameter comprises a difference between the second spatial parameter and the first spatial parameter.

WO 2019020757 A2 discloses an apparatus for decoding an encoded multichannel signal, comprises: a base channel decoder for decoding an encoded base channel to obtain a decoded base channel; a decorrelation filter for filtering at least a portion of the decoded base channel to obtain a filling signal; and a multichannel processor for performing a multichannel processing using a spectral representation of the decoded base channel and a spectral representation of the filling signal, wherein the decorrelation is a broad band filter and the multichannel processor is configured to apply a narrow band processing to the spectral representation of the decoded base channel and the spectral representation of the filling signal.

It is an object of the present invention to provide an improved concept for processing multichannel data.

This object is achieved by an apparatus for encoding a multichannel signal in accordance with claim 1, an apparatus for decoding an encoded multichannel signal in accordance with claim 23, a method of encoding a multichannel signal of claim 37, a method of decoding an encoded multichannel signal of claim 38, a computer program of claim 39 or an encoded multichannel signal of claim 40.

The present invention of a first aspect is based on the finding that, in contrast to the prior art, a different parametric encoding procedure is adopted that relies on two gain parameters, i.e., a side gain parameter and a residual gain parameter. Both gain parameters are calculated from a first channel of at least two channels of a multichannel signal and a second channel of the at least two channels of the multichannel signal. Both of these gain parameters, i.e., the side gain and the residual gain are transmitted or stored or, generally output together with a downmix signal that is calculated from the multichannel signal by a downmixer.

Embodiments of the present invention of the first aspect are based on a new mid/side approach, leading to a new set of parameters: at the encoder a mid/side transformation is applied to the input channels, which together capture the full information of two input channels. The mid signal is a weighted mean value of left and right channel, where the weights are complex and chosen to compensate for phase differences. Accordingly, the side signal is the corresponding weighted difference of the input channels. Only the mid signal is waveform coded while the side signal is modelled parametrically. The encoder operates in subbands where it extracts IPDs and two gain parameters as stereo parameter. The first gain, which will be referred to as the side gain, results from a prediction of the side signal by the mid signal and the second gain, which will be referred to as residual gain, captures the energy of the remainder relative to the energy of the mid signal. The mid signal then serves as a downmix signal, which is transmitted alongside the stereo parameters to the decoder.

The decoder synthesizes two channels by estimating the lost side channel based on the side gain and the residual gain and using a substitute for the remainder.

The present invention of the first aspect is advantageous in that the side gain on the one hand and the residual gain on the other hand are gains that are limited to a certain small range of numbers. Particularly, the side gain is, in preferred embodiments, limited to a range of -1 to +1, and the residual gain is even limited to a range of 0 and 1. And, what is even more useful in a preferred embodiment is that the residual gain depends on the side gain so that the range of values that the residual gain can have is becoming the smaller the bigger the side gain becomes.

Particularly, the side gain is calculated as a side prediction gain that is applicable to a mid signal of the first and the second channel in order to predict a side signal of the first and second channels. And the parameter calculator is also configured to calculate the residual gain as a residual prediction gain indicating an energy of or an amplitude of a residual signal of such a prediction of the side signal by the mid signal and the side gain.

Importantly, however, it is not necessary to actually perform the prediction on the encoder side or to actually encode the side signal on the encoder side. Instead, the side gain and the residual gain can be calculated by only using amplitude related measures such as energies, powers, or other characteristics related to the amplitudes of the left and the right channel. Additionally, the calculation of the side gain and the residual gain is only related to the inner product between both channels, i.e., any other channels apart from the left channel and the right channel, such as the downmix channel itself or the side channel itself are not necessary to be calculated in embodiments. However, in other embodiments, the side signal can be calculated, different trials for predictions can be calculated and the gain parameters such as the side gain and the residual gain can be calculated from a residual signal that is associated with a certain side gain prediction resulting in a predefined criterion in the different trials such as a minimum energy of the residual or remainder signal. Thus, there exists high flexibility and, nevertheless, low complexity for calculating the side gain on the one hand and the residual gain on the other hand.

There are exemplary two advantages of the gain parameters over ILD and ICC. First, they naturally lie in finite intervals (the side gain in [-1,1] and the residual gain in [0,1]) as opposed to the ILD parameter, which may take arbitrary large or small values. And second, the calculation is less complex, since it only involves a single special function evaluation, whereas the calculation of ILD and ICC involves two.

Preferred embodiments of the first aspect rely on the calculation of the parameters in the spectral domain, i.e., the parameters are calculated for different frequency bins or, more preferably, for different subbands where each subband comprises a certain number of frequency bins. In a preferred embodiment, the number of frequency bins included within a subband increases from lower to higher subbands in order to mimic the characteristic of the human listening perception, i.e., that higher bands cover higher frequency ranges or bandwidths and lower bands cover lower frequency ranges or bandwidths.

In a preferred embodiment, the downmixer calculates an absolute phase compensated downmix signal where, based on an IPD parameter, phase rotations are applied to the left and to the right channel, but the phase compensation is performed in such a way that the channel having more energy is less rotated than the channel having less energy. For controlling the phase compensation, the side gain can preferably be used, however, in other embodiments, any other downmix can be used, and this is also a specific advantage of the present invention that the parametric representation of the side signal, i.e., the side gain on the one hand and the residual gain on the other hand are calculated only based on the original first and second channels, and any information on a transmitted downmix is not required. Thus, any downmix can be used together with the new parametric representation consisting of the side gain and the residual gain, but the present invention is also particularly useful for being applied together with an absolute phase compensation that is based on the side gain.

In a further embodiment of the absolute phase compensation, the phase compensation parameter is particularly calculated based on a specific predetermined number so that the singularity of the arctangent function (atan or tan$^{-1}$) that occurs in calculating the phase compensation parameter is moved from the center to a certain side position. This shifting of the singularity makes sure that any problems due the singularity do not occur for phase shifts of +/- 180° and a gain parameter close to 0, i.e., left and right channels that have quite similar energies. Such signals have been found to occur quite often, but signals being out of phase with each other but having a difference, for example, between 3 and 12 dB or around 6 dB do not occur in natural situations. Thus, although the singularities is only shifted, it has been found that this shifting nevertheless improves the overall performance of the downmixer, since this shifting makes sure that the singularity occurs at a signal constellation situation that occurs, in normal situations, much less than where the straightforward arctangent function has its singularity point.

Further embodiments make use of the dependency of the side gain and the residual gain for implementing an efficient quantization procedure. To this end, a joint quantization is performed that relies on a joint quantization, where both parameters are quantized into a single code, and certain portions of this code rely on certain groups of quantization points that belong to a certain level difference characteristic of the two channels that are encoded by the encoder.

A second aspect relates to an apparatus for downmixing a multi-channel signal comprising at least two channels, the apparatus comprising: a downmixer for calculating a downmix signal from the multi-channel signal, wherein the downmixer is configured to calculate the downmix using an absolute phase compensation, so that a channel having a lower energy among the at least two channels is only rotated or is rotated stronger than a channel having a greater energy in calculating the downmix signal; and an output interface for generating an output signal, the output signal comprising information on the downmix signal.

Preferably the rotation is carried out preferably on the minor channel, but the case can be in small energy difference situations that the minor channel is not always rotated more than the major channel, But, if the energy ratio is sufficiently large or sufficiently small, then the preferred embodiment rotates the minor channel more than the major channel. Thus, preferably, the minor channel is rotated more than the major channel only when the energy difference is significant or is more than a predefined threshold such as 1 dB or more. This applies not only for the downmixer but also for the upmixer.

Preferred embodiments of the present invention are subsequently discussed with respect to the attached drawings, in which:

Fig. 1       is a block diagram of an apparatus for encoding a multichannel signal of an embodiment;

Fig. 2       is a block diagram of an embodiment of the parameter calculator;

Fig. 3       is a further embodiment of the parameter calculator;

Fig. 4       is an embodiment of a downmixer performing an absolute phase compensation;

Fig. 5a      is a block diagram of an embodiment of the output interface performing a specific quantization;

Fig. 5b      indicates an exemplary codeword;

Fig. 6       is an embodiment of an apparatus for decoding an encoded multichannel signal;

Fig. 7       is an embodiment of the upmixer;

Fig. 8       is an embodiment of the residual signal synthesizer;

Fig. 9       is an embodiment for the input interface;

Fig. 10a     illustrates the processing of overlapping frames;

Fig. 10b     illustrates an embodiment of the time-spectrum converter;

Fig. 10c     illustrates a spectrum of a left channel or a right channel and a construction of different subbands;

Fig. 10d     illustrates an embodiment for a spectrum-time converter;

Fig. 11      illustrates lines for a conditional quantization;

Fig. 12      illustrates lines for a joint quantization in accordance with a further embodiment; and

Fig. 13      illustrates joint quantization points for the side gain and the residual gain.

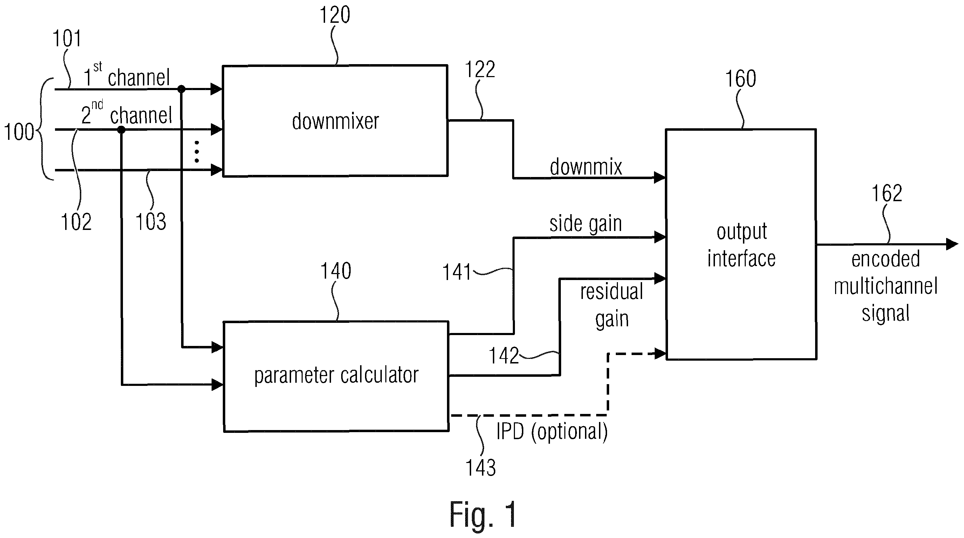

Fig. 1 illustrates an apparatus for encoding a multichannel signal comprising at least two channels. Particularly, the multichannel signal is illustrated at 100 in Fig. 1 and has a first channel 101 and a second channel 102 and no additional channels or an arbitrarily selected number of additional channels where a further additional channel is illustrated at 103.

The multichannel signal 100 is input into a downmixer 120 for calculating a downmix signal 122 from the multichannel signal 100. The downmixer can use, for calculating the multichannel signal, the first channel 101, the second channel 102 and the third channel 103 or only the first and the second channel or all channels of the multichannel signal depending on the certain implementation.

Furthermore, the apparatus for encoding comprises a parameter calculator 140 for calculating a side gain 141 from the first channel 101 and the second channel 102 of the at least two channels and, additionally, the parameter calculator 104 calculates a residual gain 142 from the first channel and the second channel. In other embodiments, an optional inter-channel phase difference (IPD) is also calculated as illustrated at 143. The downmix signal 122, the side gain 141 and the residual gain 142 are forwarded to an output interface 160 that generates an encoded multichannel signal 162 that comprises information on the downmix signal 122, on the side gain 141 and the residual gain 142.

It is to be noted that the side gain and the residual gain are typically calculated for frames so that, for each frame, a single side gain and the single residual gain is calculated. In other embodiments, however, not only a single side gain and a single residual gain is calculated for each frame, but a group of side gains and the group of residual gains are calculated for a frame where each side gain and each residual gain are related to a certain subband of the first channel and the second channel. Thus, in preferred embodiments, the parameter calculator calculates, for each frame of the first and the second channel, a group of side gains and a group of residual gains, where the number of the side and the residual gains for a frame is typically equal to the number of subbands. When a high resolution time-spectrum-conversion is applied such as a DFT, the side gain and the residual gain for a certain subband are calculated from a group of frequency bins of the first channel and the second channel. However, when a low resolution time-frequency transform is applied that results in subband signals, then the parameter calculator 140 calculates, for each subband or even for a group of subbands a side gain and a residual gain.

When the side gain and the residual gain are calculated for a group of subband signals, then the parameter resolution is reduced resulting in a lower bitrate but also resulting in a lower quality representation of the parametric representation of the side signal. In other embodiments, the time resolution can also be modified so that a side gain and a residual gain are not calculated for each frame but are calculated for a group of frames, where the group of frames has two or more frames. Thus, in such an embodiment, it is preferred to calculate subband-related side/residual gains, where the side/residual gains refer to a certain subband, but refer to a group of frames comprising two or more frames. Thus, in accordance with the present invention, the time and frequency resolution of the parameter calculation performed by block 140 can be modified with high flexibility.

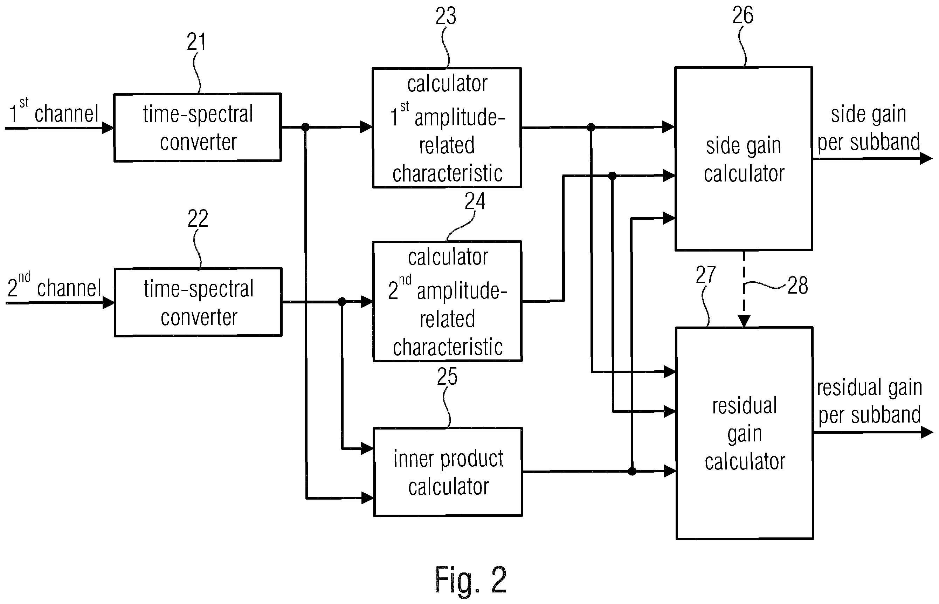

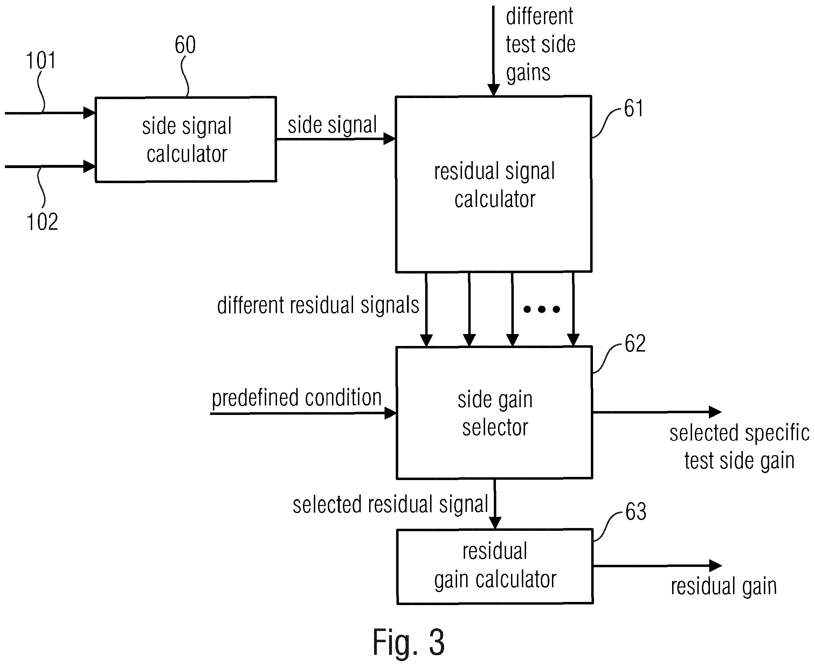

The parameter calculator 140 is preferably implemented as outlined in Fig. 2 with respect to a first embodiment or as outlined in Fig. 3 with respect to a second embodiment. In the Fig. 2 embodiment, the parameter calculator comprises a first time-spectral converter 21 and a second time-spectral converter 22. Furthermore, the parameter calculator 140 of Fig. 1 comprises a calculator 23 for calculating a first amplitude-related characteristic and a calculator 24 for calculating a second amplitude-related characteristic and a calculator 25 for calculating an inner product of the output of blocks 21 and 22, i.e., of the spectral representation of the first and second channels.

The outputs of blocks 23, 24, 25 are forwarded to a side gain calculator 26 and are also forwarded to a residual gain calculator 27. The side gain calculator 26 and the residual gain calculator 27 apply a certain relation among the first amplitude related characteristic, the second amplitude related characteristic and the inner product and the relation applied by the residual gain calculator for combining both inputs is different from the relation that is applied by the side gain calculator 26.

In a preferred embodiment, the first and the second amplitude related characteristics are energies in subbands. However, other amplitude related characteristics relate to the amplitudes in subbands themselves, relate to signal powers in subbands or relate to any other powers of amplitudes with an exponent greater than 1, where the exponent can be a real number greater than 1 or an integer number greater than 1 such an integer number of 2 relating to a signal power and an energy or relating to an number of 3 that is associated with loudness, etc. Thus, each amplitude-related characteristic can be used for calculating the side gain and the residual gain.

In a preferred embodiment, the side gain calculator and the residual gain calculator 27 are configured to calculate the side gain as a side prediction gain that is applicable to a mid-signal of the first and the second channels to predict a side signal of the first and the second channels or the parameter calculator and, particularly, the residual gain calculator 27 is configured to calculate the residual gain as a residual prediction gain indicating an amplitude related measure of a residual signal of a prediction of the side signal by the mid-signal using the side gain.

In particular, the parameter calculator 140 and the side gain calculator 26 of Fig. 2 is configured to calculate the side signal using a fraction having a nominator and a denominator, wherein the nominator comprises amplitude characteristics of the first and the second channel and the denominator comprises the amplitude characteristic of the first and the second channels and a value derived from the inner product. The value derived from the inner product is preferably the absolute value of the inner product but can alternatively be any power of the absolute value such as a power greater than 1, or can even be a characteristic different from the absolute value such as a conjugate complex term or the inner product itself or so on.

In a further embodiment, the parameter calculator the residual gain calculator 27 of Fig. 2 also uses a fraction having a nominator and a denominator both using a value derived from the inner product and, additionally, other parameters. Again, the value derived from the inner product is preferably the absolute value of the inner product but can alternatively be any power of the absolute value such as a power greater than 1, or can even be a characteristic different from the absolute value such as a conjugate complex term or the inner product itself or so on.

In particular, the side calculator 26 of Fig. 2 is configured to use, for calculating the side gain, the difference of energies of the first channels and the denominator uses a sum of the energies or amplitude characteristics of both channels and, additionally, an inner product and preferably two times the inner product but other multipliers for the inner product can also be used.

The residual gain calculator 27 is configured for using, in the nominator, a weighted sum of the amplitude characteristics of the first and the second channels and an inner product where the inner product is subtracted from the weighted sum of the amplitude characteristics of the first and the second channels. The denominator for calculating the residual gain calculator comprises a sum of the amplitude characteristics of the first and the second channel and the inner product where the inner product is preferably multiplied by two but can be multiplied by other factors as well.

Furthermore, as illustrated by the connection line 28, the residual gain calculator 27 is configured for calculating the residual gain using the side gain calculated by the side gain calculator.

In a preferred embodiment, the residual gain and the side gain operate as follows. In particular, the bandwise inter-channel phase differences that will be described later on can be calculated or not. However, before particularly outlining the calculation of the side gain as illustrated later on in equation (9) and the specific preferred calculation of the side gain as illustrated later on in equation (10), a further description of the encoder is given that also refers to a calculation of IPDs and downmixing in addition to the calculation of the gain parameters.

Encoding of stereo parameters and computation of the downmix signal is done in frequency domain. To this end, time frequency vectors $L_t$ and $R_t$ of the left and right channel are generated by simultaneously applying an analysis window followed by a discrete Fourier transform (DFT): The DFT bins are then grouped into subbands $(L_t, k)_k \in I_b$ resp. $(R_t, k)_k \in I_b$, where $I_b$ denotes the set of subbands indices.

Calculation of IPDs and Downmixing

For the downmix, a bandwise inter-channel-phase-difference (IPD) is calculated as

$$\text{IPD}_{t,b} = \arg\left( \sum_{k \in I_b} L_{t,k} R_{t,k}^* \right)$$

$$(1)$$

where $z^*$ denotes the complex conjugate of z. This is used to generate a bandwise mid and side signal

$$M_{t,k} = \frac{e^{-i\beta}L_{t,k} + e^{i(IPD_{t,b} - \beta)}R_{t,k}}{\sqrt{2}}$$

$$(2)$$

and

$$S_{t,k} = \frac{e^{-i\beta}L_{t,k} + e^{i(IPD_{t,b} - \beta)}R_{t,k}}{\sqrt{2}}$$

$$(3)$$

for $k \in I_b$. The absolute phase rotation parameter $\beta$ is given by

$$\beta = atan2\left(\sin\left(IPD_{t,b}\right), \cos\left(IPD_{t,b}\right) + 2\frac{1+g_{t,b}}{1-g_{t,b}}\right) \qquad (4)$$

where $g_{t,b}$ denotes the side gain which will be specified below. Here, atan2(y,x) is the two argument arctangent function whose value is the angle between the point *(x,y)* and the positive *x-axis.* It is intended to carry out the IPD compensation rather on the channel which has less energy. The factor 2 moves the singularity at $IPD_{t,b} = \pm\pi$ and $g_{t,b} = 0$ to $IPD_{t,b} = \pm\pi$ and $g_{t,b} = -1/3$. This way toggling of $\beta$ is avoided in out-of-phase situations with approximately equal energy distribution in left and right channel. The downmix signal is generated by applying the inverse DFT to $M_t$ followed by a synthesis window and overlap add.

In other embodiments, other arctangent functions different from atan2-function can be used as well such as a straightforward tangent function, but the atan2 function is preferred due to its safe application to the posed problem.

Calculation of gain parameters

Additional to the band-wise IPDs, two further stereo parameters are extracted. The optimal gain for predicting $S_{t,b}$ by $M_{t,b}$, i.e. the number $g_{t,b}$ such that the energy of the remainder

$$p_{t,k} = S_{t,k} - g_{t,b} M_{t,k}$$

$$(5)$$

is minimal, and a gain factor $r_{t,b}$ which, if applied to the mid signal $M_t$, equalizes the energy of $p_t$ and $M_t$ in each band, i.e.

$$r_{t,b} = \sqrt{\frac{\sum_{k\in l_b} |p_{t,k}|^2}{\sum_{k\in l_b} |M_{t,k}|^2}}$$

$$(6)$$

The optimal prediction gain can be calculated from the energies in the subbands

$$E_{L,t,b} = \sum_{k\in l_b} |L_{t,k}|^2 \quad \text{and} \quad E_{R,t,b} = \sum_{k\in l_b} |R_{t,k}|^2$$

$$(7)$$

and the absolute value of the inner product of $L_t$ and $R_t$

$$X_{L/R,t,b} = \left| \sum_{k\in l_b} L_{t,k} R_{t,k}^* \right|$$

$$(8)$$

as

$$g_{t,b} = \frac{E_{L,t,b} - E_{R,t,b}}{E_{L,t,b} + E_{R,t,b} + 2X_{L/R,t,b}}$$

$$(9)$$

From this it follows that $g_{t,b}$ lies in [-1,1]. The residual gain can be calculated similarly from the energies and the inner product as

$$r_{t,b} = \left( \frac{(1-g_{t,b})E_{L,t,b} + (1+g_{t,b})E_{R,t,b} - 2X_{L/R,t,b}}{E_{L,t,b} + E_{R,t,b} + 2X_{L/R,t,b}} \right)^{1/2}$$

$$(10)$$

which implies

$$0 \leq r_{t,b} \leq \sqrt{1 - g_{t,b}^2}$$

$$(11)$$

In particular, this shows that $r_{t,b} \in [0,1]$. This way, the stereo parameters can be calculated independently from the downmix by calculating the corresponding energies and the inner product. In particular, it is not necessary to compute the residual $p_{t,k}$ in order to compute its energy. It is noteworthy that calculation of the gains involves only one special function evaluation whereas calculation of ILD and ICC from $E_{L,t,b}$, $E_{R,t,b}$ and $X_{L/R,t,b}$ involves two, namely a square root and a logarithm:

$$\mathrm{ILD}_{t,b} = 10\,log_{10}(\frac{E_{L,t,b}}{E_{R,t,b}})$$

$$(12)$$

and

$$ICC_{t,b} = \frac{X_{L/R,t,b}}{\sqrt{E_{L,t,b} \cdot E_{R,t,b}}}$$

$$(13)$$

Lowering Parameter Resolution

If a lower parameter resolution as given by the window length is desired, one may compute the gain parameters over $h$ consecutive windows by replacing $X_{L/R,t,b}$ by

$$X_{L/R,t,b} = \sum_{s=t}^{t+h} X_{L/R,r,b}$$

$$(14)$$

and $E_{L,t,b}$ resp. $E_{R,t,b}$ by

$$\varepsilon_{L/R,t,b} = \sum_{s=t}^{t+h} E_{L/R,r,b}$$

$$(15)$$

in (9) and (10). The side gain is then a weighted average of the side gains for the individual windows where the weights depend on the energy of $M_{t+i,k}$ or depends on the bandwise energies $E_{M,s,b}$, wherein s is the summation index in equations 14 and 15.

Similarly, the IPD values are then calculated over several windows as

$$IPD_{t,b} = \arg\left( \sum_{t=t}^{t+h} \sum_{k \in l_b} L_{t,k}\ R_{t,k}^* \right)$$

$$(16)$$

Preferably, the parameter calculator 140 illustrated in Fig. 1 is configured to calculate the subband-wise representation as a sequence of complex valued spectra, where each spectrum is related to a time frame of the first channel or the second channel, where the time frames of the sequence are adjacent to each other and where adjacent time frames overlap with each other.

Furthermore, the parameter generator 140 is configured to calculate the first and the second amplitude related measures by squaring magnitudes of complex spectral values in a subband and by summing squared magnitudes in the subband as, for example, also previously illustrated in equation (7), where index b stands for the subband.

Furthermore, as also outlined in equation 8, the parameter calculator 140 and, in particular, the inner product calculator 25 of Fig. 2 is configured to calculate the inner product by summing, in a subband, the products, wherein each product involves a spectral value in a frequency bin of the first channel and a conjugate complex spectral value of the second channel for the frequency bin. Subsequently, a magnitude of a result of the summing together is formed.

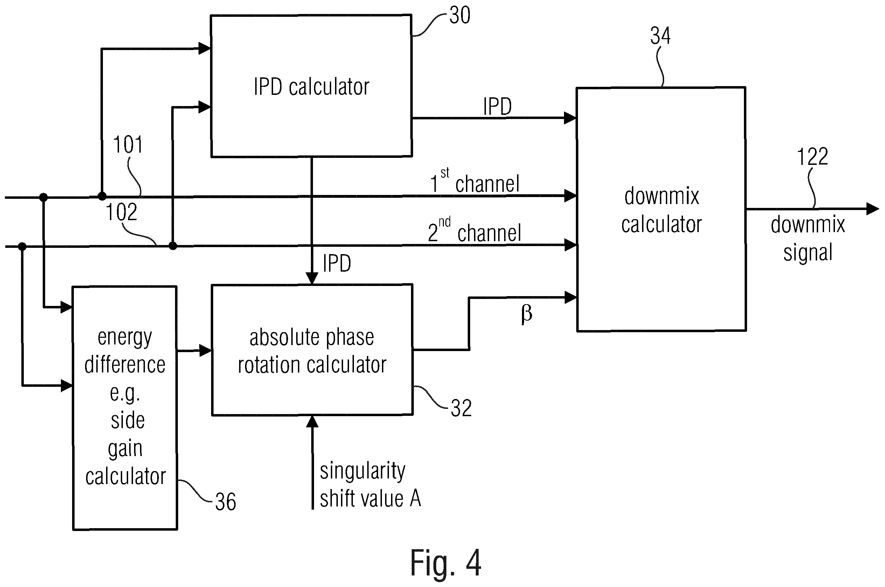

As also outlined in equations 1 to 4, it is preferred to use an absolute phase compensation. Thus, in this embodiment, the downmixer 120 is configured to calculate the downmix 122 using an absolute phase compensation so that only the channel having the lower energy among the two channels is rotated or the channel having the lower energy among the two channels is rotated stronger than the other channel that has a greater energy when calculating the downmix signal. Such a downmixer 120 is illustrated in Fig. 4. In particular, the downmixer comprises an inter-channel phase difference (IPD) calculator 30, an absolute phase rotation calculator 32, a downmix calculator 34 and an energy difference or side gain calculator 36. It is to be emphasized that the energy difference or side gain calculator 36 can be implemented as the side gain calculator 26 in Fig. 2. Alternatively, however, for the purpose of phase rotation, there can also be a different implementation in block 36 that only calculates an energy difference or, in general, an amplitude related characteristic difference that can be the energy, the power or the amplitudes themselves or powers of the amplitudes that are added together where a power is different from two such as a power between one and two or greater than two.

In particular, an exponent or power of three corresponds, for example, to the loudness rather than to the energy.

In particular, the IPD calculator 30 of Fig. 4 is configured to calculate an inter-channel phase difference typically for each subband of a plurality of subbands of each of the first and the second channels 101, 102 input into block 30. Furthermore, the downmixer has the absolute phase rotation parameter, again typically for each subband of the plurality of subbands that operates based on an energy difference provided by block 36 between the first and the second channel or, in general, based on an amplitude-related characteristic difference between both channels 101, 102. Additionally, the downmix calculator 34 is configured to weight, when calculating the downmix signal, the first and the second channels using the IPD parameters and the absolute phase rotation parameters indicated as $\beta$.

Preferably, block 36 is implemented as a side gain calculator so that the absolute phase rotation calculator operates based on the side gain.

Thus, block 30 of Fig. 4 is configured for implementing equation (1), block 32 is configured for implementing equation (4) and block 34 is configured for implementing equation (2) in a preferred embodiment.

In particular, the factor 2 in equation (4) before the term involving the side gain $g_{t,b}$ can be set different from 2 and can be, for example, a value preferably between 0.1 and 100. Naturally, also -0.1 and -100 can also be used. This value makes sure that the singularity existing at an IPD of +-180° for almost equal left and right channels is moved to a different place, i.e., to a different side gain of, for example, -1/3 for the factor 2. However, other factors different from 2 can be used. These other factors then move the singularity to a different side gain parameter from -1/3. It has been shown that all these different factors are useful since these factors achieve that the problematic singularity is at a "place" in the sound stage having associated left and right channel signals that typically occur less frequently than signals being out of phase and having equal or almost equal energy.

In the preferred embodiment, the output interface 160 of Fig. 1 is configured for performing a quantization of the parametric information, i.e., a quantization of the side gain as provided on line 141 by the parameter calculator 140 and the residual gain as provided on line 142 from the parameter calculator 140 of Fig. 1.

Particularly in the example, where the residual gain depends on the side gain, the side gain is quantized and, then, the residual gain is quantized, wherein the quantization step for the residual gain depends on the value of the side gain.

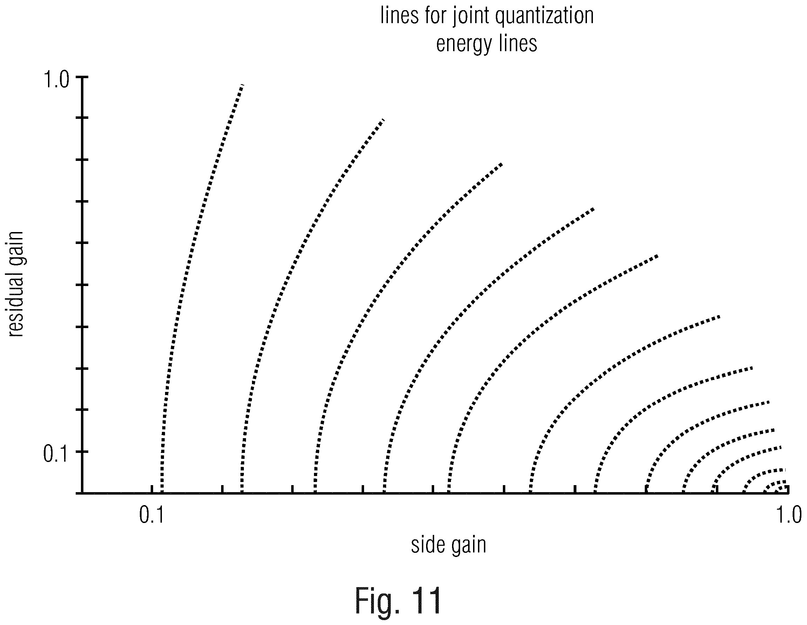

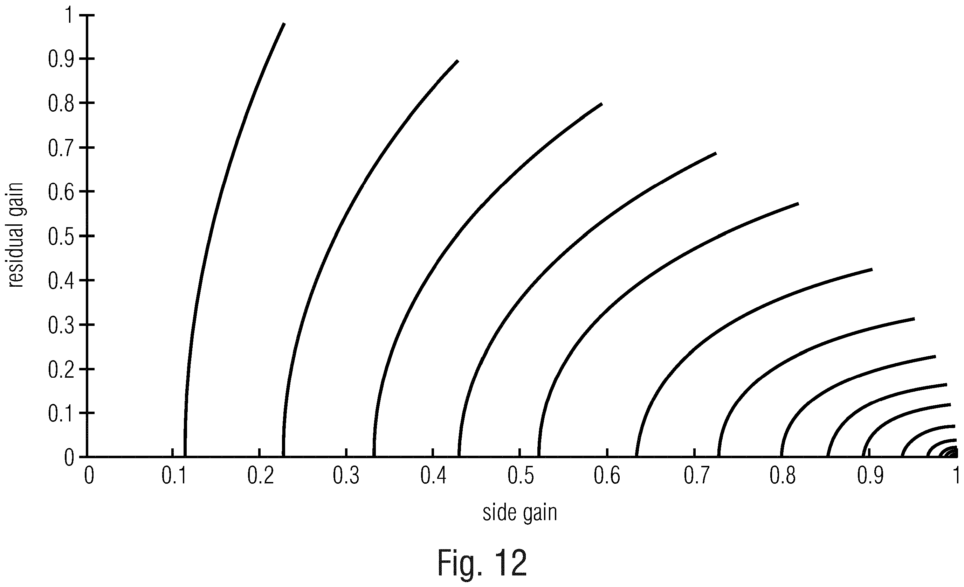

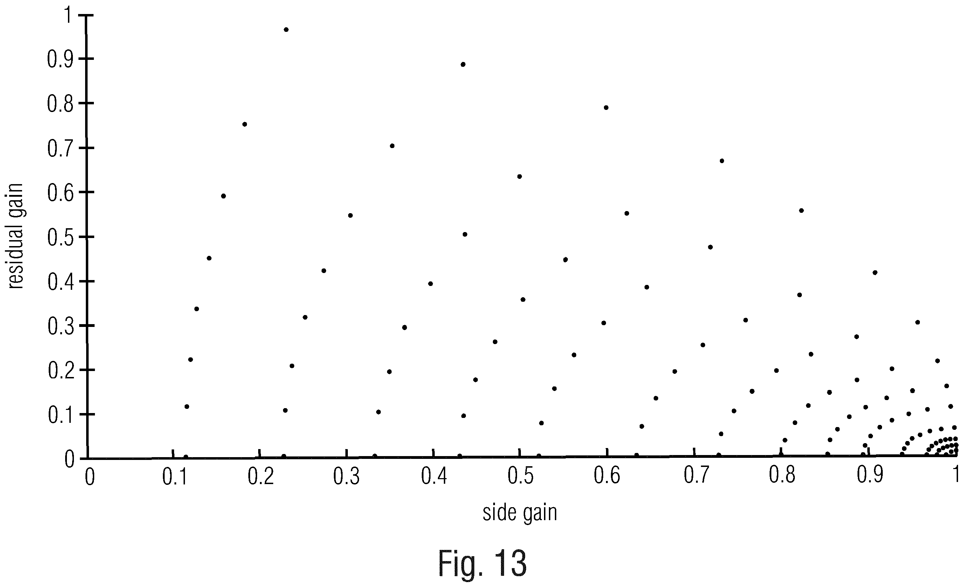

In particular, this is illustrated in Fig. 11 and analogously in Figs. 12 and 13 as well.

Fig. 11 shows the lines for the conditional quantization. In particular, it has been shown that the residual gain is always in a range determined by $(1-g^2)^{1/2}$. Thus, when g = 0, then r can be in a range between 0 and 1. However, when g is equal to 0.5, then r can be in the range of 0.866 and 0. Furthermore, when, for example, g = 0.75, then the range r is limited between 0 and 0.66. In an extreme embodiment where g = 0.9, then r can only range between 0 and 0.43. Furthermore, when g = 0.99, then r can only be in a range between 0 and 0.14, for example.

Thus, this dependency can be used by lowering the quantization step size for the quantization of the residual gain for higher side gains. Thus, when Fig. 11 is considered, the vertical lines that show the value range for r can always be divided by a certain integer number such as 8 so that each line has eight quantization steps. Thus, it is clear that for lines reflecting higher side gains, the quantization step is smaller than for lines that have lower side gains. Thus, higher side gains can be quantized more finely without any increase of bitrate.

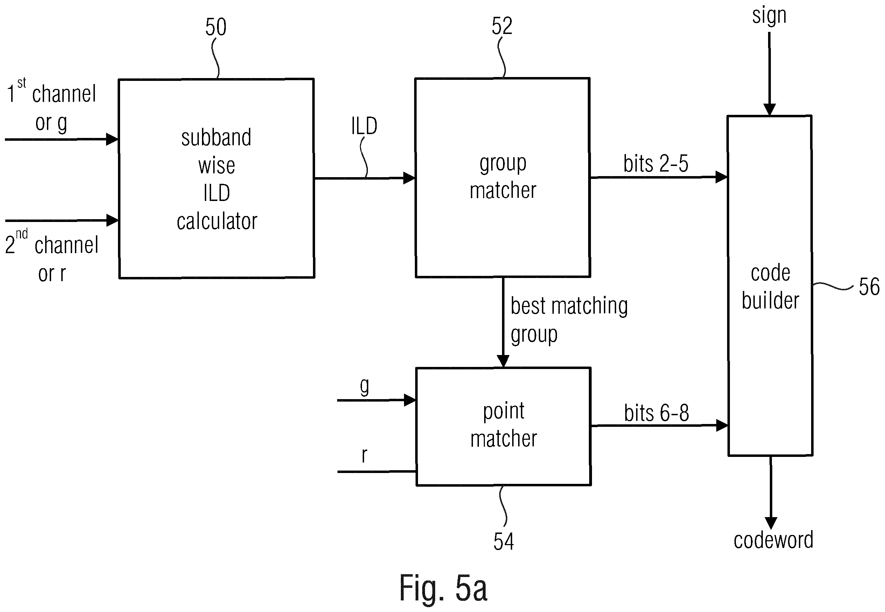

In accordance with the invention, the quantizer is configured to perform a joint quantization using groups of quantization points, where each group of quantization points is defined by a fixed amplitude-related ratio between the first and the second channel. One example for an amplitude-related ratio is the energy between left and right, i.e., this means lines for the same ILD between the first and the second channel as illustrated in Fig. 12. In this embodiment, the output interface is configured as illustrated in Fig. 5a and comprises a subband-wise ILD calculator that receives, as an input, the first channel and the second channel or, alternatively, the side gain g and the residual gain r. The subband wise ILD calculator indicated by reference numeral 50 outputs a certain ILD for parameter values g, r to be quantized. The ILD or, generally, the amplitude-related ratio is forwarded to a group matcher 52. The group matcher 52 determines the best matching group and forwards this information to a point matcher 54. Both the group matcher 52 and the point matcher 54 feed a code builder 56 that finally outputs the code such as a codeword from a codebook.

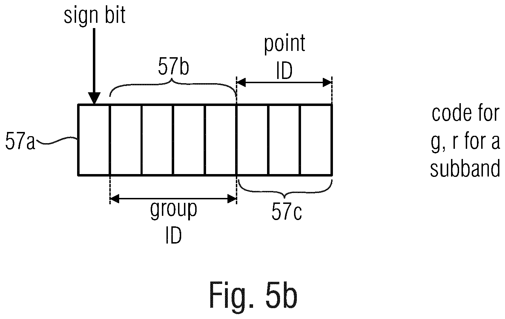

In particular, the code builder receives a sign of the side gain g and determines a sign bit 57a illustrated in Fig. 5b showing a code for g, r for a subband. Furthermore, the group matcher that has determined the certain group of quantization points matching with the determined ILD outputs bits 2 to 5 illustrated at 57b as the group ID. Finally, the point matcher outputs bits 6 to 8 in the embodiment of Fig. 5b illustrated at Fig. 57c, where these bits indicate the point ID, i.e., the ID of the quantization point within the group indicated by the bits 57b. Although Fig. 5b indicates an eight bit code having a single sign bit, four group bits and three point bits, other codes can be used having a sign bit and more or less group bits and more or less point bits. Due to the fact that the side gain has positive and negative values, the group bits and the point bits, i.e., the set of bits 57b and the set of bits 57c, only have either purely negative or, preferably, purely positive values and should the sign bit indicate an negative sign then the residual gain is decoded always as a positive value but the side gain is then decoded as a negative value which means that the energy of the left channel is lower than the energy of the right channel, when the rule as illustrated in equation 9 is applied for calculating the side gain.

Subsequently, further embodiments or examples for the quantization are outlined

Quantization of side and residual gain

The inequalities in (11) reveal a strong dependence of the residual gain on the side gain, since the latter determines the range of the first. Quantizing the side gain g and the residual gain $r$ independently by choosing quantization points in [-1,1] and [0,1] is therefore inefficient, since the number of possible quantization points for $r$ would decrease as g tends towards $\pm 1$.

Conditional Quantization

There are different ways to handle this problem. The easiest way is to quantize g first and then to quantize r conditional on the quantized value $\tilde{g}$ whence the quantization points will lie in the interval $[0, \sqrt{1 - \tilde{g}^2}]$. Quantization points can then e.g., be chosen uniformly on these quantization lines, some of which are depicted in Fig. 11.

Joint Quantization

A more sophisticated way to choose quantization points is to look at lines in the *(g, r)*-plane which correspond to a fixed energy ratio between L and R. If $c^2 \geq 1$ denotes such an energy ratio, then the corresponding line is given by either (0, s) for $0 \leq s \leq 1$ if c = 1 or

$$(s, \sqrt{\frac{(1+s)^2 - c^2(1-s)^2}{c^2 - 1}}) \quad \text{for} \quad \frac{c-1}{c+1} \leq s \leq \frac{c^2 - 1}{c^2 + 1}$$

$$(22)$$

This also covers the case $c^2 < 1$ since swapping $L_t$ and $R_t$ only changes the sign of $g_{t,b}$ and leaves $r_{t,b}$ unchanged.

This approach covers a larger region with the same number of quantization points as can be seen from Figure 12. Again, quantization points on the lines can e.g. be chosen uniformly according to the length of the individual lines. Other possibilities include choosing them in order to match pre-selected ICC- values or optimizing them in an acoustical way.

A quantization scheme that has been found to work well is based on energy lines corresponding to ILD values

$$\pm\{0, 2, 4, 6, 8, 10, 13, 16, 19, 22, 25, 30, 35, 40, 45, 50\},$$

$$(23)$$

on each of which 8 quantization points are selected. This gives rise to a code-book with 256 entries, which is organized as a 8 x 16 table of quantization points holding the values corresponding to non-negative values of g and a sign bit. This gives rise to a 8 bit integer representation of the quantization points *(g, r)* where e.g. the first bit specifies the sign of g, the next four bits hold the column index in the 8 x 16 table and the last three bits holding the row index.

Quantization of $(g_{t,b}, r_{t,b})$ could be done by an exhaustive code-book search, but it is more efficient to calculate the subband ILD first and restrict the search to the best-matching energy line. This way, only 8 points need to be considered.

Dequantization is done by a simple table lookup.

The 128 quantization points for this scheme covering the non-negative values of g are displayed in Figure 12.

Although a procedure has been disclosed for calculating the side gain and the residual gain without an actual calculation of the side signal, i.e., the difference signal between the left and the right signals as illustrated in equation (9) and equation (10), a further embodiment operates to calculate the side gain and the residual gain differently, i.e., with an actual calculation of the side signal. This procedure is illustrated in Fig. 3.

In this embodiment, the parameter calculator 140 illustrated in Fig. 1 comprises a side signal calculator 60 that receives, as an input, the first channel 101 and the second channel 102 and that outputs the actual side signal that can be in the time domain but that is preferably calculated in the frequency domain as, for example, illustrated by equation 3. However, although equation 3 indicates the situation of the calculation of the side signal with an absolute phase rotation parameter β and an IPD parameter per band and frame, the side signal can also be calculated without phase compensation. Equation 3 becomes an equation where only $L_{t,k}$ and $R_{t,k}$ occur. Thus, the side signal can also be calculated as a simple difference between left and right or first and second channels and the normalization with the square root of 2 can be used or not.

The side signal as calculated by the side signal calculator 60 is forwarded to a residual signal calculator 61. The residual signal calculator 62 performs the procedure illustrated in equation (5), for example. The residual signal calculator 61 is configured to use different test side gains, i.e., different values for the side gain $g_{d,b}$, i.e., different test side gains for one and the same band and frame and, consequently, different residual signals are obtained as illustrated by the multiple outputs of block 61.

The side gain selector 62 in Fig. 3 receives all the different residual signals and selects one of the different residual signals or, the test side gain associated with one of the different residual signals that fulfils a predefined condition. This predefined condition can, for example, be that the side gain is selected that has resulted in a residual signal having the smallest energy among all the different residual signals. However, other predetermined conditions can be used such as the smallest amplitude-related condition different from an energy such as a loudness. However, other procedures can also be applied such as that the residual signal is used that has not the smallest energy but the energy that is among the five smallest energies. Actually, a predefined condition can also be to select a residual signal that is showing a certain other audio characteristic such as certain features in certain frequency ranges.

The selected specific test side gain is determined by the side gain selector 62 as the side gain parameter for a certain frame or for a certain band and a certain frame. The selected residual signal is forwarded to the residual gain calculator 63 and the residual gain calculator can, in an embodiment, simply calculate the amplitude related characteristic of the selected residual signal or can, preferably, calculate the residual gain as a relation between the amplitude related characteristic of the residual signal with respect to the amplitude-related characteristic of the downmix signal or mid-signal. Even when a downmix is used that is different from a phase compensated downmix or is different from a downmix consisting of a sum of left and right, then the residual gain can, nevertheless, be related to a non-phase compensated addition of left and right, as the case may be.

Thus, Fig. 3 illustrates a way to calculate the side gain and the residual gain with an actual calculation of the side signal while, in the embodiment of Fig. 2 that roughly reflects equation 9 and equation 10, the side gain and the residual gain are calculated without explicit calculation of the side signal and without performing a residual signal calculation with different test side gains. Thus, it becomes clear that both embodiments result in a side gain and a residual gain parameterizing a residual signal from a prediction and other procedures for calculating the side gain and the residual gain apart from what is illustrated in Figs. 2 and 3 or by the corresponding equations 5 to 10 are also possible.

Furthermore, it is to be noted here that all the equations given are always the preferred embodiments for the values determined by the corresponding equations. However, it has been found that values that are different in a range of preferably +-20% from the values as determined by the corresponding equations are also useful and already provide advantages over the prior art, although the advantages become greater when the deviation from the values as determined by the equations becomes smaller. Thus, in other embodiments, it is preferred to use values that are only different from the values as determined by the corresponding equations by +-10% and, in a most preferred embodiment, the values determined by the equations are the values used for the calculation of the several data items.

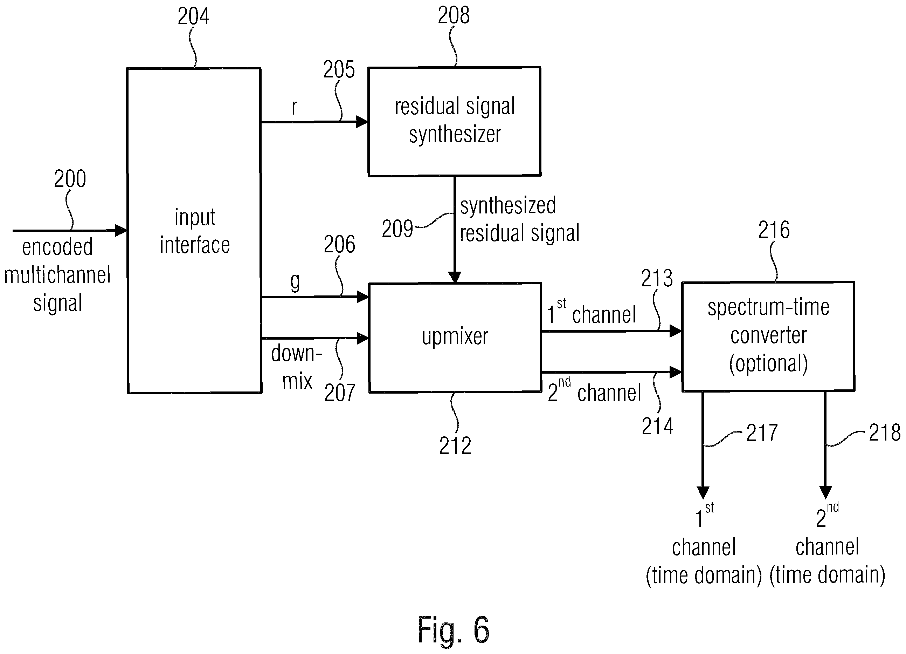

Fig. 6 illustrates an apparatus for decoding an encoded multichannel signal 200. The apparatus for decoding comprises an input interface 204, a residual signal synthesizer 208 connected to the input interface 204 and an upmixer 212 connected to the input interface 204 on the one hand and the residual synthesizer 208 on the other hand. In a preferred embodiment, the decoder additionally comprises a spectrum-time converter 260 in order to finally output time domain first and second channels as illustrated at 217 and 218.

In particular, the input interface 204 is configured for receiving the encoded multichannel signal 200 and for obtaining a downmix signal 207, a side gain g 206 and a residual gain r 205 from the encoded multichannel signal 200. The residual signal synthesizer 208 synthesizes a residual signal using the residual gain 205 and the upmixer 212 is configured for upmixing the downmix signal 207 using the side gain 206 and the residual signal 209 as determined by the residual signal synthesizer 208 to obtain a reconstructed first channel 213 and a reconstructed second channel 214. In the embodiment in which the residual signal synthesizer 208 and the upmixer 212 operate in the spectral domain or at least the upmixer 212 operates in the spectral domain, the reconstructed first and second channels 213, 214 are given in spectral domain representations and the spectral domain representation for each channel can be converted into the time domain by the spectrum-time converter 216 to finally output the time domain first and second reconstructed channels.

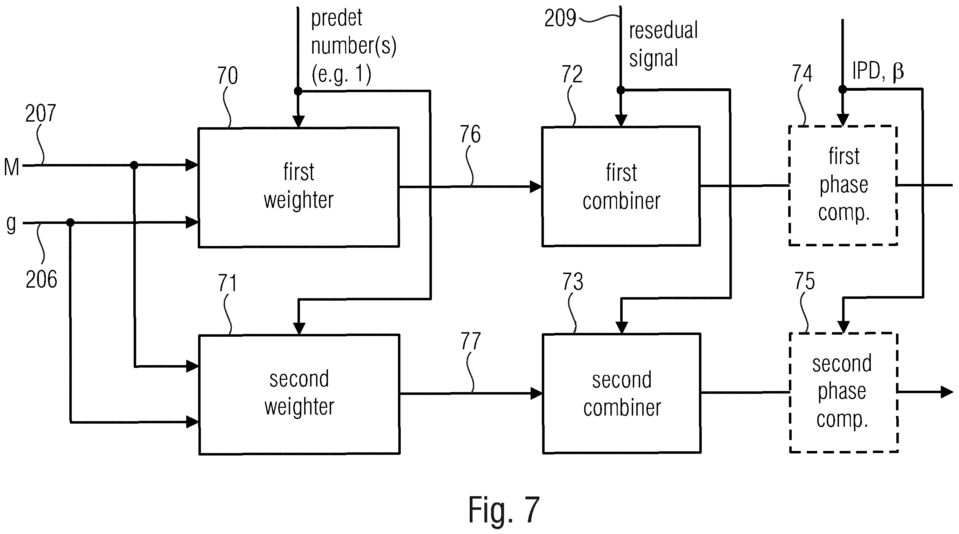

In particular, the upmixer 212 is configured to perform a first weighting operation using a first weighter 70 illustrated in Fig. 7 to obtain a first weighted downmix channel. Furthermore, the upmixer performs a second weighting operation using a second weighter again using the side gain 206 on the one hand and the downmix signal 207 on the other hand to obtain a second weighted downmix signal. Preferably, the first weighting operation performed by block 70 is different from the second weighting of operation performed by block 71 so that the first weighted downmix 76 is different from the second weighted downmix 77. Furthermore, the upmixer 212 is configured to calculate the reconstructed first channel using a combination performed by a first combiner 72 of the first weighted downmix signal 76 and the residual signal 209. Furthermore, the upmixer additionally comprises a second combiner 73 for performing a second combination of the second weighted downmix signal 77 and the residual signal 209.

Preferably, the combination rules performed by the first combiner 72 and the second combiner 73 are different from each other so that the output of block 72 on the one hand and block 73 on the other hand are substantially different to each other due to the different combining rules in block 72, 73 and due to the different weighting rules performed by block 70 and block 71.

Preferably, the first and the second combination rules are different from each other due to the fact that one combination rule is an adding operation and the other operation rule a subtracting operation. However, other pairs of first and second combination rules can be used as well.

Furthermore, the weighting rules used in block 70 and block 71 are different from each other, since one weighting rule uses a weighting with a weighting factor determined by a difference between a predetermined number and the side gain and the other weighting rule uses a weighting factor determined by a sum between a predetermined number and the side gain. The predetermined numbers can be equal to each other in both weighters or can be different from each other and the predetermined numbers are different from zero and can be integer or non-integer numbers and are preferably equal to 1.

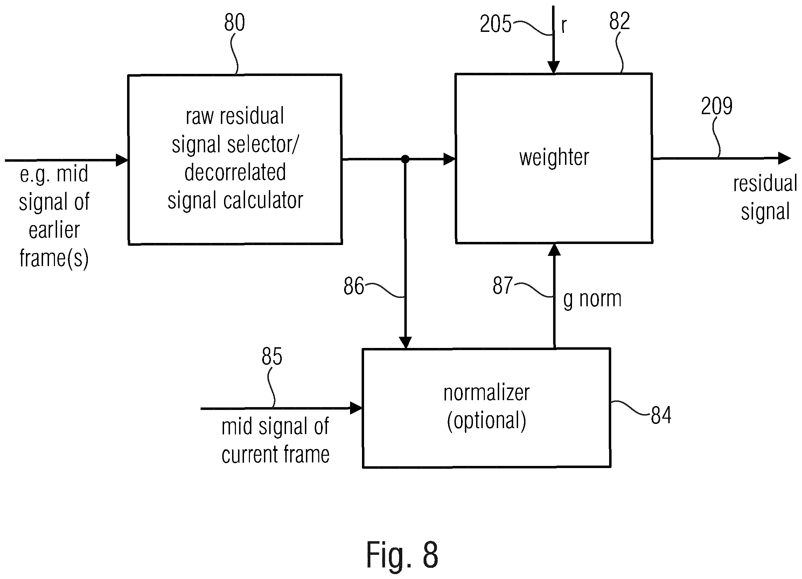

Fig. 8 illustrates a preferred implementation of the residual signal synthesizer 208. The residual signal synthesizer 208 comprises a kind of raw residual signal selector or, generally, a decorrelated signal calculator 80. Furthermore, the signal output by block 80 is input into a weighter 82 that receives, as an input, the residual gain output by the input inter face 204 of Fig. 6 indicated with the reference numeral 205. Furthermore, the residual signal synthesizer preferably comprises a normalizer 84 that receives, as an input, a mid signal of the current frame 85 and, as a further input, the signal output by block 80, i.e., the raw signal or decorrelated signal 86. Based on those two signals, the normalization factor $g_{norm}$ 87 is calculated, where the normalization factor 87 is preferably used by the weighter 82 together with the residual gain $r$ to finally obtain the synthesized residual signal 209.

In a preferred embodiment, the raw residual signal selector 80 is configured for selecting a downmix signal of a preceding frame such as the immediately preceding frame or an even earlier frame. However, and depending on the implementation, the raw residual signal selector 80 is configured for selecting the left or right signal or first or second channel signal as calculated for a preceding frame or the raw residual signal selector 80 can also determine the residual signal based on, for example, a combination such as a sum, a difference or so of the left and right signal determined for either the immediately preceding frame or an even earlier preceding frame. In other embodiments, the decorrelated signal calculator 80 can also be configured to actually generate a decorrelated signal. However, it is preferred that the raw residual signal selector 80 operates without a specific decorrelator such as a decorrelation filter such as reverberation filter, but, for low complexity reasons, only selects an already existing signal from the past such as the mid signal, the reconstructed left signal, the reconstructed right signal or a signal derived from the earlier reconstructed left and right signal by simple operations such as a weighted combination, i.e., a (weighted) addition, a (weighted) subtraction or so that does not rely on a specific reverberation or a decorrelation filter.

Generally, the weighter 82 is configured to calculate the residual signal so that an energy of the residual signal is equal to a signal energy indicated by the residual gain r, where this energy can be indicated in absolute terms, but is preferably indicated in relative terms with respect to the mid signal 207 of the current frame.

In the preferred embodiments for the encoder side and the decoder side, values of the side gain and if appropriate from the residual gain are different from zero.

Subsequently, additional preferred embodiments for the decoder are given in equation form.

The upmix is again done in frequency domain. To this end, the time-frequency transform from the encoder is applied to the decoded downmix yielding time- frequency vectors $\tilde{M}_{t,b}$.

Using the dequantized values $\tilde{IPD}_{t,b}$, $\tilde{g}_{t,b}$, and $\tilde{r}_{t,b}$, left and right channel are calculated as

$$\tilde{L}_{t,k} = \frac{e^{i\tilde{\beta}}\left(\widetilde{M}_{t,k}\left(1+\tilde{g}_{t,b}\right)+\tilde{r}_{t,b}g_{norm}\tilde{\rho}_{t,k}\right)}{\sqrt{2}} \tag{17}$$

and

$$\tilde{R}_{t,k} = \frac{e^{i\left(\tilde{\beta}-\widetilde{IPD}_b\right)}\left(\widetilde{M}_{t,k}\left(1-\tilde{g}_{t,b}\right)-\tilde{r}_{t,b}g_{norm}\tilde{\rho}_{t,k}\right)}{\sqrt{2}} \tag{18}$$

for $k \in I_b$, where $\tilde{\rho}_{t,k}$ is a substitute for the missing residual $\tilde{\rho}_{t,k}$ from the encoder, and $g_{norm}$ is the energy adjusting factor

$$\sqrt{\frac{E_{\widetilde{M},t,b}}{E_{\tilde{\rho},t,b}}} \tag{19}$$

that turns the relative gain coefficient $\tilde{r}_{t,b}$ into an absolute one. One may for instance take

$$\tilde{\rho}_{t,k} = \widetilde{M}_{t-d_b,k}, \tag{20}$$

where $d_b > 0$ denotes a band-wise frame-delay. The phase rotation factor $\tilde{\beta}$ is calculated again as

$$\tilde{\beta} = atan2(\sin\left(\tilde{IPD}_{t,b}\right), \cos\left(\tilde{IPD}_{t,b}\right) + 2\frac{1+\tilde{g}_{t,b}}{1-\tilde{g}_{t,b}}) \tag{21}$$

The left channel and the right channel are then generated by applying the inverse DFT to $\tilde{L}_t$ and $\tilde{R}_t$ followed by a synthesis window and overlap add.

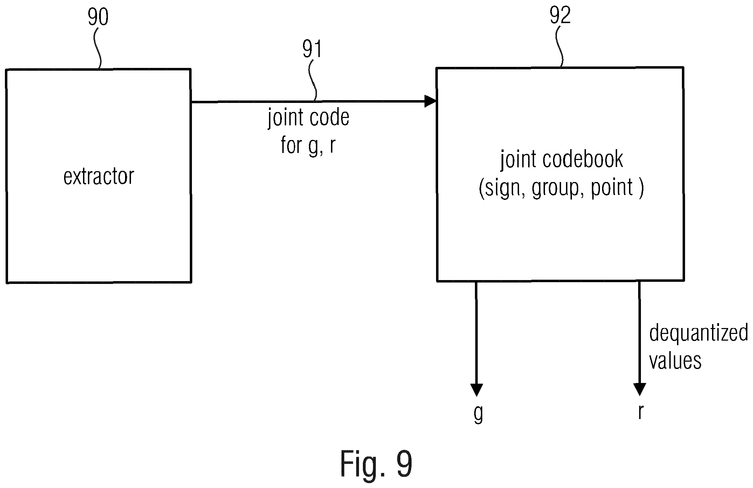

Fig. 9 illustrates a further embodiment of the input interface 204. This embodiment reflects the dequantization operation as discussed before for the encoder-side with respect to Figs. 5a and 5b. Particularly, the input interface 204 comprises an extractor 90 extracting a joint code from the encoded multichannel signal. This joint code 91 is forwarded to a joint codebook 92 that is configured to output, for each code, a sign information, a group information or a point information or to output, for each code, the final dequantized value g and the final dequantized value r, i.e., the dequantized side and residual gains.

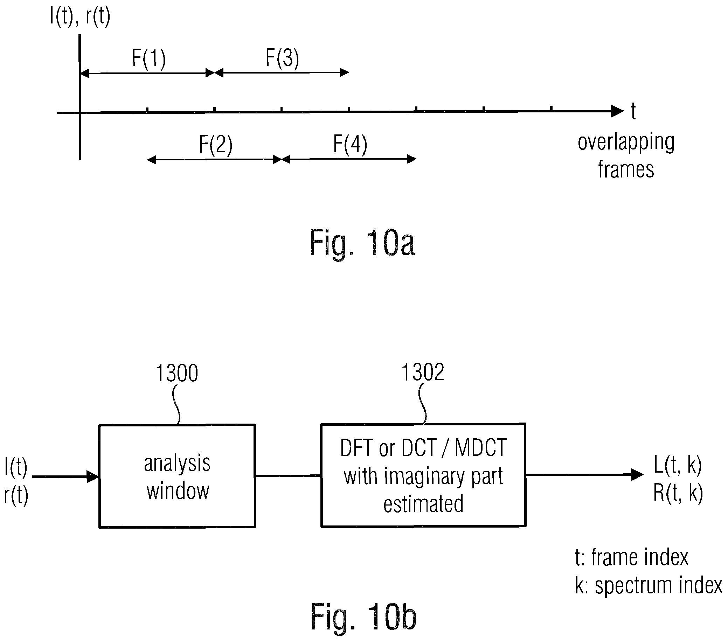

Fig. 10a illustrates a schematic representation of a time domain first and second channel or left and right channel *l(t)* and *r(t).*

In the embodiment, in which the side gain and the residual gain are calculated in the spectral domain, the left and right channels or first and second channels are separated into preferably overlapping frames F(1), F(2), F(3) and F(4) and so on. In the embodiment illustrated in Fig. 10a, the frames are overlapping by 50%, but other overlaps are useful as well. Furthermore, only a two-frame overlap is shown, i.e., that always only two subsequent frames overlap with each other. However, multi-overlap frames can be used as well, such as three, four or five overlapping frames. Then, the advance value, i.e., how much the following frame is different from the current frame is not 50% as in the embodiment illustrated in Fig. 10a, but is only smaller such as 10%, 20% or 30% or so.

Fig. 10b illustrates a preferred implementation of a time-spectral converter such as block 21 or block 22 illustrated in Fig. 2. Such a time-frequency converter receives, as an input, the sequence of frames *I(t)* or *r(t)*. The analysis windower 1300 then outputs a sequence of windowed frames that all have been windowed with preferably the same analysis window. Analysis windows can be sine windows or any other windows and a separate sequence is calculated for the first channel and a further separate sequence is calculated for the second channel.

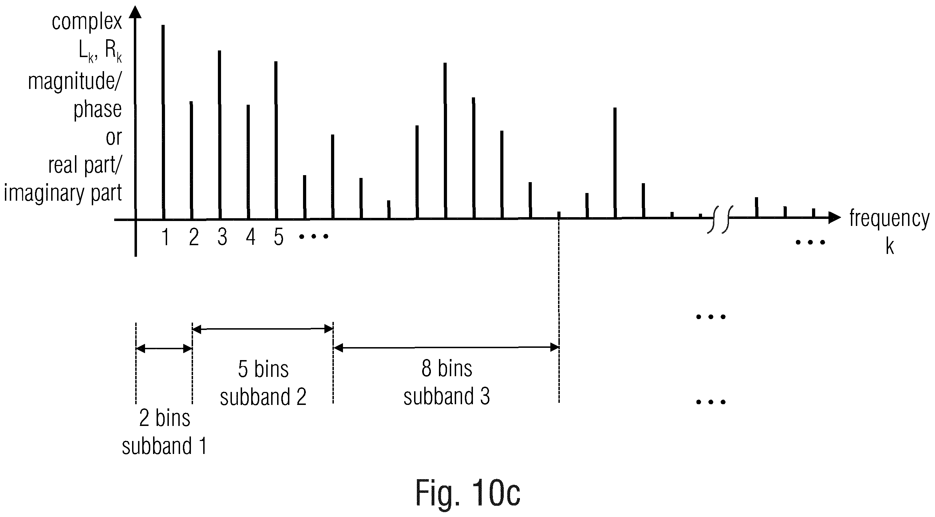

Then, the sequences of windowed frames are input into a transform block 1302. Preferably, the transform block 1302 performs a transform algorithm resulting in complex spectral values such as a DFT and, specifically, an FFT. In other embodiments, however, also a purely real transform algorithm such as a DCT or an MDCT (modified discrete cosine transform) can be used as well and, subsequently, the imaginary parts can be estimated from the purely real parts as is known in the art and as is, for example, implemented in the USAC (unified speech and audio coding) standard. Other transform algorithms can be sub-band filter banks such as QMF filter banks that result in complex-valued subband signals. Typically, subband signal filter bands have a lower frequency resolution than FFT algorithms and an FFT or DFT spectrum having a certain number of DFT bins can be transformed into a sub-band-wise representation by collecting certain bins. This is illustrated in Fig. 10c.

Particularly, Fig. 10c illustrates a complex spectrum of the frequency domain representation of the first or the second channel $L_k$, $R_k$ for a specific frame t. The spectral values are given in a magnitude/phase representation or in the real part/imaginary part representation. Typically, the DFT results in frequency bins having the same frequency resolution or bandwidth. Preferably, however, the side and residual gains are calculated subband-wise in order to reduce the number of bits for transmitting the residual and side gains. Preferably, the subband representation is generated using subbands that increase from lower to higher frequencies. Thus, in an example, subband 1 can have a first number of frequency bins such as two bins, and a second higher subband such as subband 2, subband 3, or any other subband can have a higher number of frequency bins such as, for example, eight frequency bins as illustrated by subband 3. Thus, the frequency bandwidth of the individual subbands can be preferably adjusted to the characteristics of the human ear as is known in the art with respect to the Bark scale.

Thus, Fig. 10c illustrates different frequency bins indicated by parameters k in the equations disclosed before, and the individual subbands illustrated in Fig. 10c are indicated by subband index b.

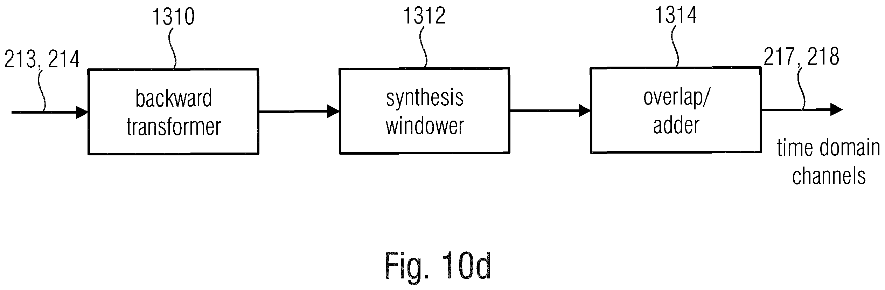

Fig. 10d illustrates an implementation of a spectrum-to-time converter as is, for example, implemented by block 216 in Fig. 6. The spectrum-time converter requires a backward transformer 1310, a subsequently connected synthesis windower 1312 and a subsequently connected overlap/adder 1314 to finally obtain the time domain channels. Thus, at the input into 1310 are the reconstructed spectral domain channels 213, 214 illustrated in Fig. 6, and at the output of the overlap/adder 1340, there exist the time domain reconstructed first and second channels 217, 218.

The backward transformer 1310 is configured to perform an algorithm resulting in a backward transform and, particularly, an algorithm that is preferably inverse to the algorithm applied in block 1302 of Fig. 10b on the encoder-side. Furthermore, the synthesis window 1312 is configured to apply a synthesis window that is matched with a corresponding analysis window and, preferably, the same analysis and synthesis windows are used, but this is not necessarily the case. The overlap adder 1314 is configured to perform an overlap as illustrated in Fig. 10a. Thus, the overlap/adder 1314, for example, takes the synthesis windowed frame corresponding to F(3) of Fig. 10a and additionally takes the synthesis windowed frame F(4) of Fig. 10a and then adds the corresponding samples of the second half of F(3) to the corresponding samples of the first half of F(4) in a sample-by-sample manner to finally obtain the samples of an actual time domain output channel.

Subsequently, different specific aspects of the present invention are given in short.

- Stereo M/S with IPD compensation and absolute phase compensation according to equation (4).
- Stereo M/S with IPD compensation and prediction of S by M according to (10)
- Stereo M/S with IPD compensation, prediction of S by M according to (9) and residual prediction according to gain factor (10)
- Efficient quantization of side and residual gain factors through joint quantization
- Joint quantization of side and residual gain factors on lines corresponding to a fixed energy ratio of $L_t$ and $R_t$ in the (g, r)-plane.

It is to be noted that, preferably, all of the above referenced five different aspects are implemented in one and the same encoder/decoder framework. However, it is additionally to be noted that the individual aspects given before can also be implemented separately from each other. Thus, the first aspect with the IPD compensation and absolute phase compensation can be performed in any downmixer irrespective of any side gain/residual gain calculation. Furthermore, for example, the aspect of the side gain calculation and the residual gain calculation can be performed with any downmix, i.e., also with a downmix that is not calculated by a certain phase compensation.

Furthermore, even the calculation of the side gain on the one hand and the residual gain on the other hand can be performed independent from each other, where the calculation of the side gain alone or together with any other parameter different from the residual gain is also advantageous over the art particularly, with respect to an ICC or ILD calculation and, even the calculation of the residual gain alone or together with any other parameter different from the side gain is also already useful.

Furthermore, the efficient joint or conditional quantization of the side and the residual gains or gain factors is useful with any particular downmix. Thus, the efficient quantization can also be used without any downmix at all. And, this efficient quantization can also be applied to any other parameters where the second parameter depends, with respect to its value range, from the first parameter so that a very efficient and low complex quantization can be performed for such dependent parameters that can, of course, be parameters different from the side gain and residual gain as well.

Thus, all of the above mentioned five aspects can be performed and implemented independent from each other or together in a certain encoder/decoder implementation, and, also, only a subgroup of the aspects can be implemented together, i.e., three aspects are implemented together without the other two aspects or only two out of the five aspects are implemented together without the other three aspects as the case may be.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Depending on certain implementation requirements, embodiments of the invention can be implemented in hardware or in software. The implementation can be performed using a digital storage medium, for example a floppy disk, a DVD, a CD, a ROM, a PROM, an EPROM, an EEPROM or a FLASH memory, having electronically readable control signals stored thereon, which cooperate (or are capable of cooperating) with a programmable computer system such that the respective method is performed.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier or a non-transitory storage medium.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

References

MPEG-4 High Efficiency Advanced Audio Coding (HE-AAC) v2
FROM JOINT STEREO TO SPATIAL AUDIO CODING - RECENT PROGRESS AND STANDARDIZATION, Proc. of the 7th Int. Conference on digital Audio Effects (DAFX-04), Naples, Italy, October 5-8, 2004.

**Claims**

1. Apparatus for encoding a multi-channel signal (100) comprising at least two channels (101, 102), comprising:

   a downmixer (120) for calculating a downmix signal (122) from the multi-channel signal (100);
   a parameter calculator (140) for calculating a side gain (141) from a first channel (101) of the at least two channels (101, 102) and a second channel (102) of the at least two channels (101, 102) and for calculating a residual gain (142) from the first channel (101) and the second channel (102); and
   an output interface (160) for generating an output signal, the output signal comprising information on the downmix signal (122), and on the side gain (141) and the residual gain (142),
   wherein the parameter calculator (140) is configured:

   to generate (21) a sub-bandwise representation of the first channel (101) and the second channel (102),
   to calculate (21, 22, 23, 24) a first amplitude-related characteristic of the first channel (101) in a sub-band and to calculate a second amplitude-related characteristic of the second channel (102) in the sub-band,
   to calculate (25) an inner product of the first channel (101) and the second channel (102) in the sub-band;
   to calculate (26) the side gain in the sub-band using a first relation involving the first amplitude-related characteristic, the second amplitude-related characteristic,
   and the inner product; and
   to calculate (27) the residual gain (142) in the sub-band using a second relation involving the first amplitude-related characteristic, the second amplitude-related characteristic, and the inner product, the second relation being different from the first relation, wherein the first amplitude-related characteristic and the second amplitude-related characteristic are determined from amplitudes, from powers, from energies or from any powers of amplitudes with an exponent greater than 1, and

   wherein the parameter calculator (140) is configured to calculate the side gain (141) and the residual gain (142) so that the residual gain (142) depends on the side gain (141), and wherein the output interface (160) is configured to perform a joint quantization using groups of quantization points, each group of quantization points being defined by a fixed amplitude-related ratio between the first channel (101) and the second channel (102).

2. Apparatus of claim 1,
   wherein the parameter calculator (140) is configured to calculate, for each sub-band of a plurality of sub-bands of the sub-bandwise representation of the first channel (101) and the second channel (102), the side gain (141) and the residual gain (142).

3. Apparatus of one of the preceding claims,
   wherein the parameter calculator (140) is configured to calculate (26) the side gain (141) using a first fraction having a first nominator and a first denominator, the first nominator involving the first amplitude-related characteristic of the first channel (101) and the second amplitude-related characteristic of the second channel (102), and the first denominator involving the first amplitude-related characteristic of the first channel (101) and the second amplitude-related characteristic of the second channel (102) and the inner product.

4. Apparatus of one of the preceding claims,
   wherein the parameter calculator (140) is configured to calculate (27) the residual gain (142) using a second fraction having a second nominator and a second denominator, the second nominator involving the inner product, and the second denominator involving the inner product.

5. Apparatus of claim 3 or 4,

   wherein the parameter calculator (140) is configured to calculate (26) the side gain (141) using the first fraction, wherein the first nominator comprises a difference of the first amplitude-related characteristic of the first channel (101) and the second amplitude-related characteristic of the second channel (102), and where the first denominator comprises a sum of the first amplitude-related characteristic of the first channel (101) and the second amplitude-related characteristic of the second channel (102) and a value derived from the inner product, or
   wherein the parameter calculator (140) is configured to calculate (27) the residual gain (142) using the second fraction having the second nominator and the second denominator, wherein the second nominator comprises a difference between a weighted sum of the first amplitude-related characteristic of the first channel (101) and the second amplitude-related characteristic of the second channel (102) and the inner product, and wherein the second denominator comprises the sum of the amplitude-related characteristic of the first channel (101), the second amplitude-related characteristic of the second channel (102) and a value derived from the inner product.

6.  Apparatus of one of the preceding claims,
    wherein the parameter calculator (140) is configured to calculate the side gain (141) for a sub-band and to calculate the residual gain (142) for the sub-band using (28) the side gain (141) for the sub-band.

7.  Apparatus of one of the preceding claims,
    wherein the parameter calculator (140) is configured to calculate the side gain (141) so that values for the side gain (141) are in a range of $\pm$ 20% of values determined based on the following equation:

$$g_{t,b} = \frac{E_{L,t,b} - E_{R,t,b}}{E_{L,t,b} + E_{R,t,b} + 2X_{L/R,t,b}} \ ,$$

wherein t is a frame index, wherein b is a sub-band index, wherein $E_l$ is an energy of the first channel (101) in the frame and the sub-band, wherein $E_R$ is an energy of the second channel (102) in the frame t and the sub-band b, and wherein X is an absolute value of the inner product between the first channel (101) and the second channel (102) in the frame t and the sub-band b.

8.  Apparatus of one of the preceding claims,
    wherein the parameter calculator (140) is configured to calculate the residual gain (142) so that values for the residual gain (142) are in a range of $\pm$ 20% of values determined based on the following equation:

$$r_{t,b} = \left(\frac{(1-g_{t,b})E_{L,t,b} + (1+g_{t,b})E_{R,t,b} - 2X_{L/R,t,b}}{E_{L,t,b} + E_{R,t,b} + 2X_{L/R,t,b}}\right)^{1/2} \ ,$$

wherein t is a frame index, wherein b is a sub-band index, wherein $E_l$ is an energy of the first channel (101) in the frame and the sub-band, wherein $E_R$ is an energy of the second channel (102) in the frame t and the sub-band b, and wherein X is an absolute value of the inner product between the first channel (101) and the second channel (102) in the frame t and the sub-band b.

9.  Apparatus of one of the preceding claims,

    wherein the parameter calculator (140) is configured to calculate the sub-bandwise representation of the first channel (101) and the second channel (102) as a sequence of complex valued spectra, wherein each spectrum is related to a time frame of the first channel (101) or the second channel (102), wherein the time frames related to the sequence of complex valued spectra are adjacent in the sequence of complex valued spectra and overlap with each other, or
    wherein the parameter calculator (140) is configured to calculate the first amplitude-related characteristic of the first channel (101) and the second amplitude-related characteristic of the second channel (102) by squaring magnitudes of complex spectral values in a sub-band and by summing squared magnitudes in the sub-band, or
    wherein the parameter calculator (140) is configured to calculate the inner product by summing, in the sub-band, products, wherein each product involves a spectral value in a frequency bin of the first channel (101) and a conjugate complex spectral value of the second channel (102) for the frequency bin, and by forming a magnitude of a result of the summing.

10. Apparatus of one of the preceding claims,
    wherein the downmixer (120) is configured to calculate the downmix signal (122) using an absolute phase compensation, wherein a channel having a lower energy is only rotated or is rotated stronger than a channel having a greater energy in calculating the downmix signal (122).

11. Apparatus of claim 10,

    wherein the downmixer (120) is configured to calculate (30) an inter-channel phase difference, and
    wherein the downmixer (120) is configured to calculate (32) an absolute phase rotation parameter, and

wherein the downmixer (120) is configured to weight (34), in calculating the downmix signal (122), the first channel (101) and the second channel (102) using the inter-channel phase difference and the absolute phase rotation parameter.

**12.** Apparatus of claim 10,
wherein the downmixer (120) is configured to calculate (32) the absolute phase rotation parameter based on the side gain (141) determined by the parameter calculator (140).

**13.** Apparatus of one of claims 11 and 12,
wherein the downmixer (120) is configured to calculate (30) the inter-channel phase difference for each sub-band of a frame, and wherein the downmixer (120) is configured to calculate (32) the absolute phase rotation parameter for each sub-band of the frame.

**14.** Apparatus of one of claims 10 to 13,
wherein the downmixer (120) is configured to calculate the absolute phase rotation parameter so that the absolute phase rotation parameter is within ± 20% of values determined by the following equation:

$$ß = \text{atan2}(\sin(IPD_{t,b}), \cos(IPD_{t,b}) + A\frac{1+g_{t,b}}{1-g_{t,b}})$$

wherein atan2 is the atan2 function, wherein β is the absolute phase rotation parameter, wherein IPD is the inter-channel phase difference, wherein t is a frame index, b is a sub-band index, and $g_{t,b}$ is the side gain (141) for the frame t and the sub-band b, and wherein A is a value between 0.1 and 100 or between -0.1 and -100.

**15.** Apparatus of one of claims 10 to 14,
wherein the downmixer (120) is configured to calculate (34) the downmix signal (122) so that the downmix signal has values within ± 20% of values determined by the following equation:

$$M_{t,k} = \frac{e^{-iß}L_{t,k} + e^{i(IPD_{t,b}-ß)}R_{t,k}}{\sqrt{2}}$$

wherein $M_{t,k}$ is the downmix signal (122) for the frame t and the frequency bin k, wherein $L_{t,k}$ is the first channel (101) for the frame t and the frequency bin k, wherein $R_{t,k}$ is the second channel (102) for the frame t and the frequency bin k, wherein $IPD_{t,b}$ is an inter-channel phase difference for the frame t and the sub-band b comprising the frequency bin k, and wherein β is the phase rotation parameter.

**16.** Apparatus of one of the preceding claims,
wherein the output interface (160) comprises a waveform encoder configured to waveform-encode the downmix signal (122) to obtain the information on the downmix signal (122).

**17.** Apparatus of claim 1, wherein the parameter calculator (140) is configured to calculate the side gain (141) so that the side gain (141) has a value range between -1 and +1, and
wherein the output interface (160) is configured to use a code having a sign bit and having side gain values being only positive or being only negative.

**18.** Apparatus of one of claims 1 or 17,
wherein the output interface (160) is configured:

to calculate (50) an inter-channel level difference between the first channel (101) and the second channel (102),
to identify (52) the group of quantization points matching with the inter-channel level difference,
to only search (54) within the identified group; and
to combine (56) a sign bit, an identification of the group and an identification of the point within the identified group to obtain a code word representing the quantized side gain and the quantized residual gain.

**19.** Apparatus of one claims 1, 17 or 18,
wherein a code book used by the output interface (160) comprises a code table with a multitude of entries, each entry being identified by binary code word, each binary code word having a sign bit, a first group of bits identifying the group of quantization points, and a second group of bits identifying a quantization point within the group of quantization points.

20. Apparatus of one of claims 1, 17, 18 or 19,
wherein a code book used by the output interface (160) comprises 16 groups of quantization points, 8 quantization points per group, and wherein a code word of the code book is an 8-bit code word with a single sign bit (57a) and a group of 4 bits (57b) identifying a group among the 16 groups and a group of 3 bits (57c) identifying a quantization point within an identified group of quantization points.

21. Apparatus of one of the preceding claims,
wherein the parameter calculator (140) is configured:

to calculate (60) the side signal from the first channel (101) and the second channel (102);
to determine (61) a plurality of residual gains from differences between the side signal and the downmix signal (122) weighted by a plurality of different test side gains;
to select (62) a specific test side gain of the plurality of different test side gains as the side gain (141), for which the residual signal fulfils a predefined condition; and
to calculate (63) the residual gain (142) from a specific residual signal determined with the specific test side gain.

22. Apparatus of claim 21,
wherein the residual gain (142) is determined from an energy of the specific residual signal and an energy of the downmix signal (122) or an energy of a sum of the first channel (101) and the second channel (102).

23. Apparatus for decoding an encoded multi-channel signal (200), comprising:

an input interface (204) for receiving the encoded multi-channel signal (200) and for obtaining a downmix signal (207), a side gain (206) and a residual gain (205) from the encoded multi-channel signal (200);
a residual signal synthesizer (208) for synthesizing a residual signal (209) using the residual gain (205); and
an upmixer (212) for upmixing the downmix signal (207) using the side gain (206) and the residual signal (209) to obtain a reconstructed first channel (213) and a reconstructed second channel (214),
wherein the upmixer (212) is configured

to perform a first weighting operation (70) of the downmix signal (207) using the side gain (206) to obtain a first weighted downmix signal (76),
to perform a second weighting operation (71) using the side gain (206) and the downmix signal (207) to obtain a second weighted downmix signal (77), wherein the first weighting operation (70) is different from the second weighting operation (71), so that the first weighted downmix signal (76) is different from the second weighted downmix signal (77), and
to calculate the reconstructed first channel (213) using a first combination (72) of the first weighted downmix signal (76) and the residual signal (209) and to calculate the reconstructed second channel (214) using a second combination (73) of the second weighted downmix signal (77) and the residual signal (209),

wherein the input interface (204) is configured to extract codewords, wherein a codeword jointly comprises a quantized side gain and a quantized residual gain, and wherein the input interface (204) is configured for dequantizing the joint codeword using a predefined codebook to obtain the side gain (206) and the residual gain (205) used by the residual signal synthesizer (208) and the upmixer (212).

24. Apparatus of claim 23,

wherein the upmixer (212) is configured to combine the weighted downmix signal (76) and the residual signal (209) using the first combination (72) in calculating the reconstructed first channel (213), and
wherein the upmixer (212) is configured to combine the second weighted downmix signal (77) and the residual signal (209) using the second combination (73) in calculating the reconstructed second channel (214), wherein the first combination rule (72) and the second combination rule (73) are different from each other.

25. Apparatus of claim 24,
wherein one of the first and the second combinations (72, 73) is an adding operation and the other of the first and the second combinations (72, 73) is a subtracting operation.

26. Apparatus of one of claims 23 to 25,

   wherein the upmixer (212) is configured to perform the first weighting operation (70) comprising a weighting factor derived from a sum of the side gain (206) and a first predetermined number, and
   wherein the upmixer (212) is configured to perform the second weighting operation (71) comprising a weighting factor derived from a difference between a second predetermined number and the side gain (206), wherein the first predetermined number and the second predetermined number are equal to each other or are different from each other.

27. Apparatus of one of claims 23 to 26,

   wherein the residual signal synthesizer (208) is configured to weight the downmix signal (207) of a preceding frame using the residual gain (205) for a current frame to obtain the residual signal (209) for the current frame, or to weight (88) a decorrelated signal derived (80) from the current frame or from one or more preceding frames using the residual gain (205) for the current frame to obtain the residual signal (209) for the current frame.

28. Apparatus of one of claims 23 to 27,
   wherein the residual signal synthesizer (208) is configured to calculate the residual signal (209) so that an energy of the residual signal (209) is equal to a signal energy indicated by the residual gain (205).

29. Apparatus of one of claims 23 to 28,
   wherein the residual signal synthesizer (208) is configured to calculate the residual signal (209) so that values of the residual signal (209) are in a range of $\pm$ 20% of values determined based on the following equation:

$$res_{t,k} = \frac{\tilde{r}_{t,b}\, g_{norm}\, \tilde{\rho}_{t,k}}{\sqrt{2}} \, ,$$

wherein $res_{t,k}$ is the residual signal (209) for frame t and frequency bin k, wherein $\tilde{r}_{t,b}$ is the residual gain (205) for the frame t and the sub-band b comprising the frequency bin k, and wherein $\tilde{\rho}_{t,k}$ is a raw signal for the residual signal (209), and wherein $g_{norm}$ is an energy-adjusting factor that can be present or not.

30. Apparatus of one of claims 23 to 29,

   wherein $g_{norm}$ is an energy-adjusting factor having values in the range of $\pm$ 20% of values determined by the following equation:

$$\sqrt{\frac{E_{\tilde{M},t,b}}{E_{\tilde{\rho},t,b}}} \, ,$$

wherein $E_{\tilde{M},t,b}$ is the energy of the downmix signal (207) for the frame t and the sub-band b, and wherein $E_{\tilde{\rho},t,b}$ is the energy of the residual signal (209) for the sub-band b and the frame t, or
wherein a raw signal for the residual signal (209) is determined based on the following equation:

$$\tilde{\rho}_{t,k} = \tilde{M}_{t-d_b,k} \, ,$$

wherein $\tilde{\rho}_{t,k}$ is the raw signal for the residual signal (209),
wherein $\tilde{M}_{t-d_b,k}$ is the downmix signal (207) for the frame t-$t_b$ and the frequency bin k, wherein $d_b$ is a frame delay greater than 0, or
wherein the upmixer (212) is configured to calculate the reconstructed first channel (213) and the reconstructed second channel (214) so that the reconstructed first channel (213) and the reconstructed second channel (214) have values that are in the range of $\pm$ 20 % with respect to values as determined by the following equations:

$$\tilde{L}_{t,k} = \frac{\left(\tilde{M}_{t,k}(1+\tilde{g}_{t,b})+\tilde{r}_{t,b}g_{norm}\tilde{\rho}_{t,k}\right)}{\sqrt{2}}$$

$$\tilde{R}_{t,k} = \frac{\left(\tilde{M}_{t,k}(1-\tilde{g}_{t,b})-\tilde{r}_{t,b}g_{norm}\tilde{\rho}_{t,k}\right)}{\sqrt{2}}$$

wherein $\tilde{M}_{t,k}$ is the downmix signal (207) for the frame t and the frequency bin k, wherein $\tilde{L}_{t,k}$ is the reconstructed first channel (213) for the frame t and the frequency bin k, wherein $\tilde{R}_{t,k}$ is the reconstructed second channel (214) for the frame t and the frequency bin k, wherein $\tilde{g}_{t,b}$ is the side gain (206) for the frame t and the subband b, wherein $\tilde{r}_{t,b}$ is the residual gain (205) for the frame t and the suband b, wherein $g_{norm}$ is an energy adjusting factor that can be there or not, and wherein $\tilde{\rho}_{t,k}$ is the raw signal for the residual signal (209) for the frame t and the frequency bin k.

31. The apparatus of one of claims 23 to 30,

wherein the input interface (204) is configured to obtain, from the encoded multichannel signal (200), inter-channel phase difference values, and
wherein the residual signal synthesizer (208) or the upmixer (212) is configured to apply the inter-channel phase difference values when calculating the residual signal or the reconstructed first channel (213) and the reconstructed second channel (214).

32. Apparatus of claim 31,

wherein the upmixer (212) is configured to calculate an absolute phase rotation parameter from an IPD inter-channel phase difference value and
to apply the absolute phase rotation parameter when calculating the reconstructed first channel (213) in a first manner and to apply the inter-channel phase difference value and/or the absolute phase rotation parameter when calculating the reconstructed second channel (214) in a second manner, wherein the first manner is different from the second manner.

33. Apparatus of claim 32,
wherein the upmixer (212) is configured to calculate the absolute phase rotation parameter so that the absolute phase rotation parameter is within ± 20% of values determined by the following equation:

$$\text{ß} = \text{atan2}(\sin\left(IPD_{t,b}\right), \cos\left(IPD_{t,b}\right) + A\,\frac{1+g_{t,b}}{1-g_{t,b}})$$

wherein atan2 is the atan2 function, wherein β is the absolute phase rotation parameter, wherein IPD is the inter-channel phase difference, wherein t is a frame index, b is a sub-band index, and $g_{t,b}$ is the side gain (206) for the frame t and the sub-band b, and wherein A is a value between 0.1 and 100 or between -0.1 and -100.

34. Apparatus of claim 23,
wherein a code book used by the input interface (204) comprises 16 groups of quantization points, 8 quantization points per group, and wherein a code word of the code book is an 8-bit code word with a single sign bit (57a) and a group of 4 bits (57b) identifying a group among the 16 groups and a group of 3 bits (57c) identifying a quantization point within an identified group of quantization points.

35. Apparatus of one of claims 23 to 34,

wherein the upmixer (212) is configured to calculate the reconstructed first channel (213) and the reconstructed second channel (214) in a spectral domain,
wherein the apparatus further comprises a spectrum-time converter (216) for converting the reconstructed first channel (213) and the reconstructed second channel (214) into a time domain.

36. Apparatus of claim 28,

wherein the spectrum-time converter (216) is configured to (301) convert, for each one of the reconstructed first channel (213) and the reconstructed second channel (214), subsequent frames into a time sequence of frames, to weight (1312) each time frame using a synthesis window; and

to overlap and add (1314) subsequent windowed time frames to obtain a time block of the reconstructed first channel (213) and a time block of the reconstructed second channel (214).

37. Method of encoding a multi-channel signal (100) comprising at least two channels (101, 102), comprising:

calculating (120) a downmix signal (122) from the multi-channel signal (100);

calculating (140) a side gain (141) from a first channel (101) of the at least two channels (101, 102) and a second channel (102) of the at least two channels (101, 102) and calculating a residual gain (142) from the first channel (101) and the second channel (102); and

generating (160) an output signal, the output signal comprising information on the downmix signal (122), and on the side gain (141) and the residual gain (142),

wherein the calculating (140) comprises generating (21) a sub-bandwise representation of the first channel and the second channel, calculating (21, 22, 23, 24) a first amplitude-related characteristic of the first channel in a sub-band and calculating a second amplitude-related characteristic of the second channel in the sub-band, calculating (25) an inner product of the first channel and the second channel in the sub-band; calculating (26) the side gain in the sub-band using a first relation involving the first amplitude-related characteristic, the second amplitude-related characteristic, and the inner product; and calculating (27) the residual gain (142) in the sub-band using a second relation involving the first amplitude-related characteristic, the second amplitude-related characteristic, and the inner product, the second relation being different from the first relation, wherein the first amplitude-related characteristic and the second amplitude-related characteristic are determined from amplitudes, from powers, from energies or from any powers of amplitudes with an exponent greater than 1,

wherein the calculating (140) comprises calculating the side gain (141) and the residual gain (142) so that the residual gain (142) depends on the side gain (141), and wherein the generating (160) comprises performing a joint quantization using groups of quantization points, each group of quantization points being defined by a fixed amplitude-related ratio between the first channel (101) and the second channel (102).

38. Method of decoding an encoded multi-channel signal (200), comprising:

receiving (204) the encoded multi-channel signal (200) and for obtaining a downmix signal (207), a side gain (206) and a residual gain (205) from the encoded multi-channel signal (200);

synthesizing (208) a residual signal (209) using the residual gain (205); and

upmixing (212) the downmix signal (207) using the side gain (206) and the residual signal (209) to obtain a reconstructed first channel (213) and a reconstructed second channel (214),

wherein the upmixing (212) comprises performing a first weighting operation (70) of the downmix signal (207) using the side gain (206) to obtain a first weighted downmix signal (76), performing a second weighting operation (71) using the side gain (206) and the downmix signal (207) to obtain a second weighted downmix signal (77), wherein the first weighting operation (70) is different from the second weighting operation (71), so that the first weighted downmix signal (76) is different from the second weighted downmix signal (77), and calculating the reconstructed first channel (213) using a combination (72) of the first weighted downmix signal (76) and the residual signal (209) and calculating the reconstructed second channel (214) using a second combination (73) of the second weighted downmix signal (77) and the residual signal (209),

wherein the receiving (204) comprises extracting codewords, wherein a codeword jointly comprises a quantized side gain and a quantized residual gain, and wherein receiving (204) comprises dequantizing the joint codeword using a predefined codebook to obtain the side gain (206) and the residual gain (205) used by the synthesizing (208) and the upmixing (212).

39. Computer program for performing, when running on a computer or a processor, the method of claim 37 or the method of claim 38.

40. Encoded multi-channel signal (200) comprising:

information on a downmix signal (207), and

codewords, wherein a codeword jointly comprises a quantized side gain (206), and a quantized residual gain (205),

wherein the side gain (206) in a sub-band represents a first relation involving a first amplitude-related characteristic, a second amplitude-related characteristic, and an inner product; wherein the residual gain (205) in the sub-band represents a second relation involving the first amplitude-related characteristic, the second amplitude-related characteristic, and the inner product, the second relation being different from the first relation, wherein the first amplitude-related characteristic and the second amplitude-related characteristic are determined from amplitudes, from powers, from energies or from any powers of amplitudes with an exponent greater than 1.

**Patentansprüche**

1. Vorrichtung zum Codieren eines Mehrkanalsignals (100), das zumindest zwei Kanäle (101, 102) aufweist, wobei die Vorrichtung folgende Merkmale aufweist:

einen Abwärtsmischer (120) zum Berechnen (34) eines Abwärtsmischsignals (122) aus dem Mehrkanalsignal (100);

eine Parameterberechnungseinrichtung (140) zum Berechnen eines Seitengewinns (141) aus einem ersten Kanal (101) der zumindest zwei Kanäle (101, 102) und einem zweiten Kanal (102) der zumindest zwei Kanäle (101, 102) und zum Berechnen eines Restgewinns (142) aus dem ersten Kanal (101) und dem zweiten Kanal (102); und

eine Ausgangsschnittstelle (160) zum Erzeugen eines Ausgangssignals, wobei das Ausgangssignal Informationen über das Abwärtsmischsignal (122) und über den Seitengewinn (141) und den Restgewinn (142) aufweist, wobei die Parameterberechnungseinrichtung (140) dazu ausgebildet ist,

eine teilbandweise Darstellung des ersten Kanals (101) und des zweiten Kanals (102) zu erzeugen (21), eine erste amplitudenbezogene Charakteristik des ersten Kanals (101) in einem Teilband zu berechnen (21, 22, 23, 24) und eine zweite amplitudenbezogene Charakteristik des zweiten Kanals (102) in dem Teilband zu berechnen,

ein inneres Produkt des ersten Kanals (101) und des zweiten Kanals (102) in dem Teilband zu berechnen (25);

den Seitengewinn in dem Teilband unter Verwendung einer ersten Beziehung zu berechnen (26), die die erste amplitudenbezogene Charakteristik, die zweite amplitudenbezogene Charakteristik und das innere Produkt beinhaltet; und

den Restgewinn (142) in dem Teilband unter Verwendung einer zweiten Beziehung zu berechnen (27), die die erste amplitudenbezogene Charakteristik, die zweite amplitudenbezogene Charakteristik und das innere Produkt beinhaltet, wobei sich die zweite Beziehung von der ersten Beziehung unterscheidet, wobei die erste amplitudenbezogene Charakteristik und die zweite amplitudenbezogene Charakteristik aus Amplituden, aus Potenzen, aus Energien oder aus beliebigen Potenzen von Amplituden mit einem Exponenten bestimmt werden, der größer ist als 1, und

wobei die Parameterberechnungseinrichtung (140) dazu ausgebildet ist, den Seitengewinn (141) und den Restgewinn (142) so zu berechnen, dass der Restgewinn (142) von dem Seitengewinn (141) abhängt, und wobei die Ausgangsschnittstelle (160) dazu ausgebildet ist, eine gemeinsame Quantisierung unter Verwendung von Gruppen von Quantisierungspunkten durchzuführen, wobei jede Gruppe von Quantisierungspunkten definiert ist durch ein festes amplitudenbezogenes Verhältnis zwischen dem ersten Kanal (101) und dem zweiten Kanal (102).

2. Vorrichtung gemäß Anspruch 1,
wobei die Parameterberechnungseinrichtung (140) dazu ausgebildet ist, für jedes Teilband einer Mehrzahl von Teilbändern der teilbandweisen Darstellung des ersten Kanals (101) und des zweiten Kanals (102) den Seitengewinn (141) oder den Restgewinn (142) zu berechnen.

3. Vorrichtung gemäß einem der vorhergehenden Ansprüche,
wobei die Parameterberechnungseinrichtung (140) dazu ausgebildet ist, den Seitengewinn (141) unter Verwendung eines ersten Bruchs mit einem ersten Zähler und einem ersten Nenner zu berechnen, wobei der erste Zähler die erste amplitudenbezogene Charakteristik des ersten Kanals (101) und die amplitudenbezogene Charakteristik des zweiten Kanals (102) beinhaltet, und wobei der erste Nenner die erste amplitudenbezogene Charakteristik des ersten Kanals (101) und die zweite amplitudenbezogene Charakteristik des zweiten Kanals (102) und das innere Produkt beinhaltet.

**4.** Vorrichtung gemäß einem der vorhergehenden Ansprüche,
wobei die Parameterberechnungseinrichtung (140) dazu ausgebildet ist, den Restgewinn (142) unter Verwendung eines zweiten Bruchs mit einem zweiten Zähler und einem zweiten Nenner zu berechnen (27), wobei der zweite Zähler das innere Produkt beinhaltet und der zweite Nenner das innere Produkt beinhaltet.

**5.** Vorrichtung gemäß Anspruch 3 oder 4,

wobei die Parameterberechnungseinrichtung (140) dazu ausgebildet ist, den Seitengewinn (141) unter Verwendung des ersten Bruchs zu berechnen (26), wobei der erste Zähler eine Differenz aus der ersten amplitudenbezogenen Charakteristik des ersten Kanals (101) und der zweiten amplitudenbezogenen Charakteristik des zweiten Kanals (102) aufweist, und wobei der erste Nenner eine Summe aus der ersten amplitudenbezogenen Charakteristik des ersten Kanals (101) und der zweiten amplitudenbezogenen Charakteristik des zweiten Kanals (102) und einen von dem inneren Produkt abgeleiteten Wert aufweist, oder
wobei die Parameterberechnungseinrichtung (140) dazu ausgebildet ist, den Restgewinn (142) unter Verwendung des zweiten Bruchs mit dem zweiten Zähler und dem zweiten Nenner zu berechnen (27), wobei der zweite Zähler eine Differenz zwischen einer gewichteten Summe aus der ersten amplitudenbezogenen Charakteristik des ersten Kanals (101) und der zweiten amplitudenbezogenen Charakteristik des zweiten Kanals (102) und dem inneren Produkt aufweist, und wobei der zweite Nenner die Summe aus der amplitudenbezogenen Charakteristik des ersten Kanals (101), der zweiten amplitudenbezogenen Charakteristik des zweiten Kanals (102) und einem von dem inneren Produkt abgeleiteten Wert aufweist.

**6.** Vorrichtung gemäß einem der vorhergehenden Ansprüche,
wobei die Parameterberechnungseinrichtung (140) dazu ausgebildet ist, den Seitengewinn (141) für ein Teilband zu berechnen und den Restgewinn (142) für das Teilband unter Verwendung (28) des Seitengewinns (141) für das Teilband zu berechnen.

**7.** Vorrichtung gemäß einem der vorhergehenden Ansprüche,
wobei die Parameterberechnungseinrichtung (140) dazu ausgebildet ist, den Seitengewinn (141) zu berechnen, so dass Werte für den Seitengewinn (141) in einem Bereich von ± 20 % von Werten liegen, die auf der Basis der folgenden Gleichung bestimmt werden:

$$g_{t,b} = \frac{E_{L,t,b} - E_{R,t,b}}{E_{L,t,b} + E_{R,t,b} + 2X_{L/R,t,b}} \, ,$$

wobei t ein Rahmenindex ist, wobei b ein Teilbandindex ist, wobei $E_l$ eine Energie des ersten Kanals (101) in dem Rahmen und dem Teilband ist, wobei $E_R$ eine Energie des zweiten Kanals (102) in dem Rahmen t und dem Teilband b ist, und wobei X ein absoluter Wert des inneren Produkts zwischen dem ersten Kanal (101) und dem zweiten Kanal (102) in dem Rahmen t und dem Teilband b ist.

**8.** Vorrichtung gemäß einem der vorhergehenden Ansprüche,
wobei die Parameterberechnungseinrichtung (140) dazu ausgebildet ist, den Restgewinn (142) zu berechnen, so dass Werte für den Restgewinn (142) in einem Bereich von ± 20 % von Werten liegen, die auf der Basis der folgenden Gleichung bestimmt werden:

$$r_{t,b} = \left( \frac{(1 - g_{t,b})E_{L,t,b} + (1 + g_{t,b})E_{R,t,b} - 2X_{L/R,t,b}}{E_{L,t,b} + E_{R,t,b} + 2X_{L/R,t,b}} \right)^{1/2} \, ,$$

wobei t ein Rahmenindex ist, wobei b ein Teilbandindex ist, wobei $E_l$ eine Energie des ersten Kanals (101) in dem Rahmen und dem Teilband ist, wobei $E_R$ eine Energie des zweiten Kanals (102) in dem Rahmen t und dem Teilband b ist, und wobei X ein absoluter Wert des inneren Produkts zwischen dem ersten Kanal (101) und dem zweiten Kanal (102) in dem Rahmen t und dem Teilband b ist.

**9.** Vorrichtung gemäß einem der vorhergehenden Ansprüche,

wobei die Parameterberechnungseinrichtung (140) dazu ausgebildet ist, eine teilbandweise Darstellung des ersten Kanals (101) und des zweiten Kanals (102) als eine Sequenz komplexwertiger Spektren zu berechnen, wobei jedes Spektrum auf einen Zeitrahmen des ersten Kanals (101) oder des zweiten Kanals (102) bezogen ist, wobei die Zeitrahmen, die auf die Sequenz komplexwertiger Spektren bezogen sind, in der Sequenz komplexwertiger Spektren benachbart sind und einander überlappen, oder

wobei die Parameterberechnungseinrichtung (140) dazu ausgebildet ist, die erste amplitudenbezogene Charakteristik des ersten Kanals (101) und die zweite amplitudenbezogene Charakteristik des zweiten Kanals (102) durch Quadrieren von Beträgen komplexer Spektralwerte in einem Teilband und durch Summieren quadrierter Beträge in dem Teilband zu berechnen, oder

wobei die Parameterberechnungseinrichtung (140) dazu ausgebildet ist, das innere Produkt zu berechnen, indem Produkte in dem Teilband summiert werden, wobei jedes Produkt einen Spektralwert in einem Frequenzintervallbereich des ersten Kanals (101) und einen konjugiert-komplexen Spektralwert des zweiten Kanals (102) für den Frequenzintervallbereich beinhaltet, und indem ein Betrag eines Ergebnisses des Summierens gebildet wird.

10. Vorrichtung gemäß einem der vorhergehenden Ansprüche,
wobei der Abwärtsmischer (120) dazu ausgebildet ist, das Abwärtsmischsignal (122) unter Verwendung einer Absolutphasenkompensation zu berechnen, wobei aus dem Mehrkanalsignal (100), wobei beim Berechnen des Abwärtsmischsignals (122) nur ein Kanal mit einer niedrigeren Energie gedreht wird oder stärker gedreht wird als ein Kanal mit einer größeren Energie.

11. Vorrichtung gemäß Anspruch 10,

wobei der Abwärtsmischer (120) dazu ausgebildet ist, eine Zwischenkanalphasendifferenz zu berechnen (30), und

wobei der Abwärtsmischer (120) dazu ausgebildet ist, einen Absolutphasendrehungsparameter zu berechnen (32), und

wobei der Abwärtsmischer (120) dazu ausgebildet ist, bei dem Berechnen des Abwärtsmischsignals (122) den ersten Kanal (101) und den zweiten Kanal (102) unter Verwendung der Zwischenkanalphasendifferenz und des Absolutphasendrehungsparameters zu gewichten (34).

12. Vorrichtung gemäß Anspruch 10,
wobei der Abwärtsmischer (120) dazu ausgebildet ist, den Absolutphasendrehungsparameter auf der Basis des Seitengewinns (141) zu berechnen (32), der durch die Parameterberechnungseinrichtung (140) bestimmt wird.

13. Vorrichtung gemäß einem der Ansprüche 11 und 12,
wobei der Abwärtsmischer (120) dazu ausgebildet ist, die Zwischenkanalphasendifferenz für jedes Teilband eines Rahmens zu berechnen (30), und wobei der Abwärtsmischer (120) dazu ausgebildet ist, den Absolutphasendrehungsparameter für jedes Teilband des Rahmens zu berechnen (32).

14. Vorrichtung gemäß einem der Ansprüche 10 bis 13,
wobei der Abwärtsmischer (120) dazu ausgebildet ist, den Absolutphasendrehungsparameter zu berechnen, so dass der Absolutphasendrehungsparameter innerhalb von ± 20 % von Werten liegt, die durch die folgende Gleichung bestimmt werden:

$$ß = atan2\left(\sin\left(IPD_{t,b}\right), \cos\left(IPD_{t,b}\right) + A\,\frac{1+g_{t,b}}{1-g_{t,b}}\right)$$

wobei atan2 die atan2-Funktion ist, wobei ß der Absolutphasendrehungsparameter ist, wobei IPD die Zwischenkanalphasendifferenz ist, wobei t ein Rahmenindex ist, b ein Teilbandindex ist und $g_{t,b}$ der Seitengewinn (141) für den Rahmen t und das Teilband b ist, und wobei A ein Wert zwischen 0,1 und 100 oder zwischen -0,1 und -100 ist.

15. Vorrichtung gemäß einem der Ansprüche 10 bis 14,
wobei der Abwärtsmischer (120) dazu ausgebildet ist, das Abwärtsmischsignal (122) zu berechnen (34), so dass das Abwärtsmischsignal (122) Werte innerhalb von ± 20 % von Werten aufweist, die durch die folgende Gleichung bestimmt werden:

$$M_{t,k} = \frac{e^{-i\beta}L_{t,k} + e^{i(IPD_{t,b}-\beta)}R_{t,k}}{\sqrt{2}}$$

wobei $M_{t,k}$ das Abwärtsmischsignal (122) für den Rahmen t und den Frequenzintervallbereich k ist, wobei $L_{t,k}$ der erste Kanal (101) für den Rahmen t und den Frequenzintervallbereich k ist, wobei $R_{t,k}$ der zweite Kanal (102) für den Rahmen t und den Frequenzintervallbereich k ist, wobei $IPD_{t,b}$ eine Zwischenkanalphasendifferenz für den Rahmen t und das Teilband b ist, das den Frequenzintervallbereich k aufweist, und wobei ß der Phasendrehungsparameter ist.

16. Vorrichtung gemäß einem der vorhergehenden Ansprüche,
wobei die Ausgangsschnittstelle (160) einen Signalverlaufcodierer aufweist, der dazu ausgebildet ist, das Abwärtsmischsignal (122) einer Signalverlaufcodierung zu unterziehen, um die Informationen über das Abwärtsmischsignal (122) zu erhalten,

17. Vorrichtung gemäß Anspruch 1, wobei die Parameterberechnungseinrichtung (140) dazu ausgebildet ist, den Seitengewinn (141) zu berechnen, so dass der Seitengewinn (141) einen Wertebereich zwischen -1 und +1 aufweist, und wobei die Ausgangsschnittstelle (160) dazu ausgebildet ist, einen Code zu verwenden, der ein Vorzeichenbit aufweist und der Seitengewinnwerte aufweist, die nur positiv oder nur negativ sind.

18. Vorrichtung gemäß einem der Ansprüche 1 oder 17,

wobei die Ausgangsschnittstelle (160) dazu ausgebildet ist,
eine Zwischenkanalpegeldifferenz zwischen dem ersten Kanal (101) und dem zweiten Kanal (102) zu berechnen (50),
die Gruppe von Quantisierungspunkten zu identifizieren (52), die mit der Zwischenkanalpegeldifferenz zusammenpassen,
nur innerhalb der identifizierten Gruppe zu suchen (54); und
ein Vorzeichenbit, eine Identifizierung der Gruppe und eine Identifizierung des Punkts innerhalb der identifizierten Gruppe zu kombinieren (56), um ein Codewort zu erhalten, das den quantisierten Seitengewinn und den quantisierten Restgewinn darstellt.

19. Vorrichtung gemäß einem der Ansprüche 1, 17 oder 18,
wobei ein Codebuch, das durch die Ausgangsschnittstelle (160) verwendet wird, eine Codetabelle mit einer Vielzahl von Einträgen aufweist, wobei jeder Eintrag durch ein Binärcodewort identifiziert wird, wobei jedes Binärcodewort ein Vorzeichenbit, eine erste Gruppe von Bits, die die Gruppe von Quantisierungspunkten identifiziert, und eine zweite Gruppe von Bits aufweist, die einen Quantisierungspunkt innerhalb der Gruppe von Quantisierungspunkten identifiziert.

20. Vorrichtung gemäß einem der Ansprüche 1, 17, 18 oder 19,
wobei ein Codebuch, das durch die Ausgangsschnittstelle (160) verwendet wird, 16 Gruppen von Quantisierungspunkten aufweist, 8 Quantisierungspunkte pro Gruppe, und wobei ein Codewort des Codebuchs ein 8-Bit-Codewort mit einem einzelnen Vorzeichenbit (57a) und einer Gruppe von 4 Bits (57b), die eine Gruppe unter den 16 Gruppen identifiziert, und einer Gruppe von 3 Bits (57c) ist, die einen Quantisierungspunkt innerhalb einer identifizierten Gruppe von Quantisierungspunkten identifiziert.

21. Vorrichtung gemäß einem der vorhergehenden Ansprüche,

wobei die Parameterberechnungseinrichtung (140) ausgebildet ist,
um das Seitensignal aus dem ersten Kanal (101) und dem zweiten Kanal (102) der zu berechnen (60);
eine Mehrzahl von Restgewinnen aus Differenzen zwischen dem Seitensignal und dem Abwärtsmischsignal (122) zu bestimmen (61), die durch eine Mehrzahl unterschiedlicher Testseitengewinne gewichtet sind;
einen spezifischen Testseitengewinn der Mehrzahl unterschiedlicher Testseitengewinne als den Seitengewinn (141) auszuwählen (62), für den das Restsignal eine vordefinierte Bedingung erfüllt; und

den Restgewinn (142) aus einem spezifischen Restsignal zu berechnen (63), das mit den spezifischen Testseitengewinn bestimmt wird.

22. Vorrichtung gemäß Anspruch 21,
wobei der Restgewinn (142) aus einer Energie des spezifischen Restsignals und einer Energie des Abwärtsmischsignals (122) oder einer Energie einer Summe des ersten Kanals (101) und des zweiten Kanals (102) bestimmt wird.

23. Vorrichtung zum Decodieren eines codierten Mehrkanalsignals (200), die folgende Merkmale aufweist:

eine Eingangsschnittstelle (204) zum Empfangen des codierten Mehrkanalsignals (200) und zum Erhalten eines Abwärtsmischsignals (207), eines Seitengewinns (206) und eines Restgewinns (205) aus dem codierten Mehrkanalsignal (200);
einen Restsignalsynthetisierer (208) zum Synthetisieren eines Restsignals (209) unter Verwendung des Restgewinns (205);
einen Aufwärtsmischer (212) zum Aufwärtsmischen des Abwärtsmischsignals (207) unter Verwendung des Seitengewinns (206) und des Restsignals (209), um einen rekonstruierten ersten Kanal (213) und einen rekonstruierten zweiten Kanal (214) zu erhalten,
wobei der Aufwärtsmischer (212) dazu ausgebildet ist,

einen ersten Gewichtungsvorgang (70) des Abwärtsmischsignals (207) unter Verwendung des Seitengewinns (206) durchzuführen, um ein erstes gewichtetes Abwärtsmischsignal (76) zu erhalten,
einen zweiten Gewichtungsvorgang (71) unter Verwendung des Seitengewinns (206) und des Abwärtsmischsignals (207) durchzuführen, um ein zweites gewichtetes Abwärtsmischsignal (77) zu erhalten, wobei sich der erste Gewichtungsvorgang (70) von dem zweiten Gewichtungsvorgang (71) unterscheidet, so dass sich das erste gewichtete Abwärtsmischsignal (76) von dem zweiten gewichteten Abwärtsmischsignal (77) unterscheidet, und
den rekonstruierten ersten Kanal (213) unter Verwendung einer ersten Kombination (72) aus dem ersten gewichteten Abwärtsmischsignal (76) und dem Restsignal (209) zu berechnen und den rekonstruierten zweiten Kanal (214) unter Verwendung einer zweiten Kombination (73) aus dem zweiten gewichteten Abwärtsmischsignal (77) und dem Restsignal (209) zu berechnen,

wobei die Eingangsschnittstelle (204) dazu ausgebildet ist, Codewörter zu extrahieren, wobei ein Codewort gemeinsam einen quantisierten Seitengewinn und einen quantisierten Restgewinn aufweist, und wobei die Eingangsschnittstelle (204) zum Quantisieren des gemeinsamen Codeworts unter Verwendung eines vordefinierten Codebuchs ausgebildet ist, um den Seitengewinn (206) und den Restgewinn (205) zu erhalten, die durch den Restsignalsynthetisierer (208) und den Aufwärtsmischer (212) verwendet werden.

24. Vorrichtung gemäß Anspruch 23,

wobei der Aufwärtsmischer (212) dazu ausgebildet ist, das gewichtete Abwärtsmischsignal (76) und das Restsignal (209) unter Verwendung der ersten Kombination (72) bei dem Berechnen des rekonstruierten ersten Kanals (213) zu kombinieren, und
wobei der Aufwärtsmischer (212) dazu ausgebildet ist, das zweite gewichtete Abwärtsmischsignal (77) und das Restsignal (209) unter Verwendung der zweiten Kombination (73) bei dem Berechnen des rekonstruierten zweiten Kanals (214) zu kombinieren, wobei sich die erste Kombinationsregel (72) und die zweite Kombinationsregel (73) voneinander unterscheiden.

25. Vorrichtung gemäß Anspruch 24,
wobei eine der ersten und der zweiten Kombination (72, 73) eine Additionsoperation und die andere der ersten und der zweiten Kombination eine Subtraktionsoperation ist.

26. Vorrichtung gemäß einem der Ansprüche 23 bis 25,

wobei der Aufwärtsmischer (212) dazu ausgebildet ist, den ersten Gewichtungsvorgang (70) durchzuführen, der einen Gewichtungsfaktor aufweist, der von einer Summe aus dem Seitengewinn (206) und einer ersten vorbestimmten Zahl abgeleitet ist, und
wobei der Aufwärtsmischer (212) dazu ausgebildet ist, den zweiten Gewichtungsvorgang (71) durchzuführen, der einen Gewichtungsfaktor aufweist, der von einer Differenz zwischen einer zweiten vorbestimmten Zahl und dem Seitengewinn (206) abgeleitet ist, wobei die erste vorbestimmte Zahl und die zweite vorbestimmte Zahl gleich oder voneinander verschieden sind.

**27.** Vorrichtung gemäß einem der Ansprüche 23 bis 26,

wobei der Restsignalsynthetisierer (208) dazu ausgebildet ist, ein Abwärtsmischsignal (207) eines vorhergehenden Rahmens unter Verwendung des Restgewinns (209) für einen aktuellen Rahmen zu gewichten, um das Restsignal (209) für den aktuellen Rahmen zu erhalten, oder
ein dekorreliertes Signal, das von dem aktuellen Rahmen oder von einem oder mehreren vorhergehenden Rahmen abgeleitet (80) ist, unter Verwendung des Restsignals (205) für den aktuellen Rahmen zu gewichten (88), um das Restsignal (209) für den aktuellen Rahmen zu erhalten.

**28.** Vorrichtung gemäß einem der Ansprüche 23 bis 27,
wobei der Restsignalsynthetisierer (208) dazu ausgebildet ist, das Restsignal (209) zu berechnen, so dass eine Energie des Restsignals (209) gleich einer Signalenergie ist, die durch den Restgewinn (205) angezeigt ist.

**29.** Vorrichtung gemäß einem der Ansprüche 23 bis 28,
wobei der Restsignalsynthetisierer (208) dazu ausgebildet ist, das Restsignal (209) zu berechnen, so dass Werte des Restsignals (209) in einem Bereich von ± 20 % von Werten liegen, die auf der Basis der folgenden Gleichung bestimmt werden:

$$res_{t,k} = \frac{\tilde{r}_{t,b}\, g_{norm}\, \tilde{\rho}_{t,k}}{\sqrt{2}},$$

wobei $res_{t,k}$ das Restsignal (209) für den Rahmen t und den Frequenzintervallbereich k ist, wobei $\tilde{r}_{t,b}$ der Restgewinn (205) für den Rahmen t und das Teilband b ist, das den Frequenzintervallbereich k aufweist, und wobei $\tilde{\rho}_{t,k}$ ein Rohsignal für das Restsignal (209) ist, und wobei $g_{norm}$ ein energieanpassender Faktor ist, der vorhanden sein kann oder nicht.

**30.** Vorrichtung gemäß einem der Ansprüche 23 bis 29,

wobei $g_{norm}$ ein energieanpassender Faktor mit Werten in dem Bereich von ± 20 % von Werten ist, die durch die folgende Gleichung bestimmt werden:

$$\sqrt{\frac{E_{\tilde{M},t,b}}{E_{\tilde{\rho},t,b}}},$$

wobei $E_{\tilde{M},t,b}$ die Energie des Abwärtsmischsignals (207) für den Rahmen t und das Teilband b ist, und wobei $E_{\tilde{\rho},t,b}$ die Energie des Restsignals (209) für das Teilband b und den Rahmen t ist, oder
wobei ein Rohsignal für das Restsignal (209) auf der Basis der folgenden Gleichung bestimmt wird:

$$\tilde{\rho}_{t,k} = \tilde{M}_{t-d_b,k},$$

wobei $\tilde{\rho}_{t,k}$ das Rohsignal für das Restsignal (209) ist,
wobei $\tilde{M}_{t-d_b,k}$ das Abwärtsmischsignal (207) für den Rahmen t-$t_b$ und den Frequenzintervallbereich k ist, wobei $d_b$ eine Rahmenverzögerung ist, die größer ist als 0, oder
wobei der Aufwärtsmischer (212) dazu ausgebildet ist, den rekonstruierten ersten Kanal (213) und den rekonstruierten zweiten Kanal (214) zu berechnen, so dass der rekonstruierte erste Kanal (213) und der rekonstruierte zweite Kanal (214) Werte aufweisen, die in dem Bereich von ± 20 % in Bezug auf Werte liegen, wie sie durch die folgenden Gleichungen bestimmt werden:

$$\widetilde{L}_{t,k} = \frac{\left(\widetilde{M}_{t,k}\left(1+\widetilde{g}_{t,b}\right)+\widetilde{r}_{t,b}g_{norm}\widetilde{p}_{t,k}\right)}{\sqrt{2}}$$

und

$$\widetilde{R}_{t,k} = \frac{\left(\widetilde{M}_{t,k}\left(1-\widetilde{g}_{t,b}\right)-\widetilde{r}_{t,b}g_{norm}\widetilde{p}_{t,k}\right)}{\sqrt{2}}$$

wobei $\widetilde{M}_{t,k}$ das Abwärtsmischsignal (207) für den Rahmen t und den Frequenzintervallbereich k ist, wobei $\widetilde{L}_{t,b}$ der rekonstruierte erste Kanal (213) für den Rahmen t und den Frequenzintervallbereich k ist, wobei $\widetilde{R}_{t,k}$ der rekonstruierte zweite Kanal (214) für den Rahmen t und den Frequenzintervallbereich k ist, wobei $\widetilde{g}_{t,b}$ der Seitengewinn (206) für den Rahmen t und das Teilband b ist, wobei $\widetilde{r}_{t,b}$ der Restgewinn (205) für den Rahmen t und das Teilband b ist, wobei $g_{norm}$ ein energieanpassender Faktor ist, der vorhanden sein kann oder nicht, und wobei $\widetilde{p}_{t,k}$ ein rohes Signal für das Restsignal (209) für den Rahmen t und den Frequenzintervallbereich k ist.

**31.** Vorrichtung gemäß einem der Ansprüche 23 bis 30,
wobei die Eingangsschnittstelle (204) dazu ausgebildet ist, aus dem codierten Mehrkanalsignal (200) Zwischenkanalphasendifferenzwerte zu erhalten, und wobei der Restsignalsynthetisierer (208) oder der Aufwärtsmischer (212) dazu ausgebildet ist, die Zwischenkanalphasendifferenzwerte bei einem Berechnen des Restsignals oder des rekonstruierten ersten Kanals (213) und des rekonstruierten zweiten Kanals (214) anzuwenden.

**32.** Vorrichtung gemäß Anspruch 31,

wobei der Aufwärtsmischer (212) dazu ausgebildet ist, einen Absolutphasendrehungsparameter aus einem IPD-Zwischenkanalphasendifferenzwert zu berechnen und
den Absolutphasendrehungsparameter bei dem Berechnen des rekonstruierten ersten Kanals (213) auf eine erste Weise anzuwenden und den Zwischenkanalphasendifferenzwert und/oder den Absolutphasendrehungsparameter bei dem Berechnen des rekonstruierten zweiten Kanals (214) auf eine zweite Weise anzuwenden, wobei sich die erste Weise von der zweiten Weise unterscheidet.

**33.** Vorrichtung gemäß Anspruch 32,
wobei der Aufwärtsmischer (212) dazu ausgebildet ist, den Absolutphasendrehungsparameter zu berechnen, so dass der Absolutphasendrehungsparameter innerhalb von $\pm$ 20 % von Werten liegt, die durch die folgende Gleichung bestimmt werden:

$$ß = \text{atan2}\left(\sin\left(IPD_{t,b}\right),\cos\left(IPD_{t,b}\right)+A\frac{1+g_{t,b}}{1-g_{t,b}}\right)$$

wobei atan2 die atan2-Funktion ist, wobei ß der Absolutphasendrehungsparameter ist, wobei IPD die Zwischenkanalphasendifferenz ist, wobei t ein Rahmenindex ist, b ein Teilbandindex ist und $g_{t,b}$ der Seitengewinn (206) für den Rahmen t und das Teilband b ist, und wobei A ein Wert zwischen 0,1 und 100 oder zwischen -0,1 und -100 ist.

**34.** Vorrichtung gemäß Anspruch 23,
wobei ein Codebuch, das durch die Eingangsschnittstelle (204) verwendet wird, 16 Gruppen von Quantisierungspunkten aufweist, 8 Quantisierungspunkte pro Gruppe, und wobei ein Codewort des Codebuchs ein 8-Bit-Codewort mit einem einzelnen Vorzeichenbit (57a) und einer Gruppe von 4 Bits (57b), die eine Gruppe unter den 16 Gruppen identifiziert, und einer Gruppe von 3 Bits (57c) ist, die einen Quantisierungspunkt innerhalb einer identifizierten Gruppe von Quantisierungspunkten identifiziert.

**35.** Vorrichtung gemäß einem der Ansprüche 23 bis 34,

wobei der Aufwärtsmischer (212) dazu ausgebildet ist, den rekonstruierten ersten Kanal (213) und den rekonstruierten zweiten Kanal (214) in einem Spektralbereich zu berechnen, wobei die Vorrichtung ferner einen Spektrum-Zeit-Wandler (216) zum Umwandeln des rekonstruierten ersten Kanals (213) und des rekonstruierten zweiten Kanals (214) in einen Zeitbereich aufweist.

**36.** Vorrichtung gemäß Anspruch 28,

wobei der Spektrum-Zeit-Wandler (216) dazu ausgebildet ist, für sowohl den rekonstruierten ersten Kanal (213) als auch den rekonstruierten zweiten Kanal (214) nachfolgende Rahmen in eine Zeitsequenz von Rahmen umzuwandeln (301), jeden Zeitrahmen unter Verwendung eines Synthesefensters zu gewichten (1312); und aufeinanderfolgende gefensterte Zeitrahmen zu überlappen und zu addieren (1314), um einen Zeitblock des rekonstruierten ersten Kanals (213) und einen Zeitblock des rekonstruierten zweiten Kanals (214) zu erhalten.

**37.** Verfahren zum Codieren eines Mehrkanalsignals (100), das zumindest zwei Kanäle (101, 102) aufweist, wobei das Verfahren folgende Schritte aufweist:

Berechnen (120) eines Abwärtsmischsignals (122) aus dem Mehrkanalsignal (100); Berechnen (140) eines Seitengewinns (141) aus einem ersten Kanal (101) der zumindest zwei Kanäle (101, 102) und einem zweiten Kanal (102) der zumindest zwei Kanäle (101, 102) und Berechnen eines Restgewinns (142) aus dem ersten Kanal (101) und dem zweiten Kanal (102); und Erzeugen (160) eines Ausgangssignals, wobei das Ausgangssignal Informationen über das Abwärtsmischsignal (122) und über den Seitengewinn (141) und den Restgewinn (142) aufweist, wobei das Berechnen (140) ein Erzeugen (21) einer teilbandweisen Darstellung des ersten Kanals und des zweiten Kanals, Berechnen (21, 22, 23, 24) einer ersten amplitudenbezogenen Charakteristik des ersten Kanals in einem Teilband und Berechnen einer zweiten amplitudenbezogenen Charakteristik des zweiten Kanals in dem Teilband, Berechnen (25) eines inneren Produkts des ersten Kanals und des zweiten Kanals in dem Teilband; Berechnen (26) des Seitengewinns in dem Teilband unter Verwendung einer ersten Beziehung, die die erste amplitudenbezogene Charakteristik, die zweite amplitudenbezogene Charakteristik und das innere Produkt beinhaltet; und Berechnen (27) des Restgewinns (142) in dem Teilband unter Verwendung einer zweiten Beziehung, die die erste amplitudenbezogene Charakteristik, die zweite amplitudenbezogene Charakteristik und das innere Produkt beinhaltet, aufweist, wobei sich die zweite Beziehung von der ersten Beziehung unterscheidet, wobei die erste amplitudenbezogene Charakteristik und die zweite amplitudenbezogene Charakteristik aus Amplituden, aus Potenzen, aus Energien oder aus beliebigen Potenzen von Amplituden mit einem Exponenten bestimmt werden, der größer ist als 1, und wobei das Berechnen (140) ein Berechnen des Seitengewinns (141) und des Restgewinns (142) aufweist, so dass der Restgewinn (142) von dem Seitengewinn (141) abhängt, und wobei das Erzeugen (160) ein Durchführen einer gemeinsamen Quantisierung unter Verwendung von Gruppen von Quantisierungspunkten aufweist, wobei jede Gruppe von Quantisierungspunkten definiert ist durch ein festes amplitudenbezogenes Verhältnis zwischen dem ersten Kanal (101) und dem zweiten Kanal (102).

**38.** Verfahren zum Decodieren eines codierten Mehrkanalsignals (200), das folgende Schritte aufweist:

Empfangen (204) des codierten Mehrkanalsignals (200) und zum Erhalten eines Abwärtsmischsignals (207), eines Seitengewinns (206) und eines Restgewinns (205) aus dem codierten Mehrkanalsignal (200); Synthetisieren (208) eines Restsignals (209) unter Verwendung des Restgewinns (205); und Aufwärtsmischen (212) des Abwärtsmischsignals (207) unter Verwendung des Seitengewinns (206) und des Restsignals (209), um einen rekonstruierten ersten Kanal (213) und einen rekonstruierten zweiten Kanal (214) zu erhalten, wobei das Aufwärtsmischen (212) ein Durchführen eines ersten Gewichtungsvorgangs (70) des Abwärtsmischsignals (207) unter Verwendung des Seitengewinns (206), um ein erstes gewichtetes Abwärtsmischsignal (76) zu erhalten, Durchführen eines zweiten Gewichtungsvorgangs (71) unter Verwendung des Seitengewinns (206) und des Abwärtsmischsignals (207), um ein zweites gewichtetes Abwärtsmischsignal (77) zu erhalten, wobei sich der erste Gewichtungsvorgang (70) von dem zweiten Gewichtungsvorgang (71) unterscheidet, so dass sich das erste gewichtete Abwärtsmischsignal (76) von dem zweiten gewichteten Abwärtsmischsignal (77) unterscheidet, und Berechnen des rekonstruierten ersten Kanals (213) unter Verwendung einer ersten Kombination (72) aus dem ersten gewichteten Abwärtsmischsignal (76) und dem Restsignal (209) und Berechnen des rekonstruierten zweiten Kanals (214) unter Verwendung einer zweiten Kombination (73) aus dem zweiten gewichteten Abwärtsmischsignal (77) und dem Restsignal (209) aufweist, wobei das Empfangen (204) ein Extrahieren von Codewörtern aufweist, wobei ein Codewort gemeinsam einen quantisierten Seitengewinn und einen quantisierten Restgewinn aufweist, und wobei das Empfangen (204) ein Quantisieren des gemeinsamen Codeworts unter Verwendung eines vordefinierten Codebuchs aufweist, um den Seitengewinn (206) und den Restgewinn (205) zu erhalten, die durch das Synthetisieren (208) und das Aufwärtsmischen (212) verwendet werden.

39. Computerprogramm zum Durchführen, wenn dasselbe auf einem Computer oder einem Prozessor läuft, des Verfahrens gemäß Anspruch 37 oder des Verfahrens gemäß Anspruch 38.

40. Codiertes Mehrkanalsignal (200), das folgende Merkmale aufweist:

Informationen über ein Abwärtsmischsignal (207) und
Codewörter, wobei ein Codewort gemeinsam einen quantisierten Seitengewinn (206) und einen quantisierten Restgewinn (205) aufweist,
wobei der Seitengewinn (206) in einem Teilband eine erste Beziehung darstellt, die eine erste amplitudenbezogene Charakteristik, eine zweite amplitudenbezogene Charakteristik und ein inneres Produkt beinhaltet;
wobei der Restgewinn (205) in dem Teilband eine zweite Beziehung darstellt, die die erste amplitudenbezogene Charakteristik, die zweite amplitudenbezogene Charakteristik und das innere Produkt beinhaltet, wobei sich die zweite Beziehung von der ersten Beziehung unterscheidet, wobei die erste amplitudenbezogene Charakteristik und die zweite amplitudenbezogene Charakteristik aus Amplituden, aus Potenzen, aus Energien oder aus beliebigen Potenzen von Amplituden mit einem Exponenten bestimmt werden, der größer ist als 1.

**Revendications**

1. Appareil de codage d'un signal multicanal (100) comprenant au moins deux canaux (101, 102), comprenant:

un mélangeur vers le bas (120) destiné à calculer un signal de mélange vers le bas (122) à partir du signal multicanal (100);
un calculateur de paramètres (140) destiné à calculer un gain latéral (141) à partir d'un premier canal (101) des au moins deux canaux (101, 102) et d'un deuxième canal (102) des au moins deux canaux (101, 102) et à calculer un gain résiduel (142) à partir du premier canal (101) et du deuxième canal (102); et
une interface de sortie (160) destinée à générer un signal de sortie, le signal de sortie comprenant les informations sur le signal de mélange vers le bas (122) et sur le gain latéral (141) et le gain résiduel (142),
dans lequel le calculateur de paramètres (140) est configuré:

pour générer (21) une représentation par sous-bande du premier canal (101) et du deuxième canal (102),
pour calculer (21, 22, 23, 24) une première caractéristique relative à l'amplitude du premier canal (101) dans une sous-bande et pour calculer une deuxième caractéristique relative à l'amplitude du deuxième canal (102) dans la sous-bande,
pour calculer (25) un produit interne du premier canal (101) et du deuxième canal (102) dans la sous-bande;
pour calculer (26) le gain latéral dans la sous-bande à l'aide d'un premier rapport impliquant la première caractéristique relative à l'amplitude, la deuxième caractéristique relative à l'amplitude et le produit interne; et
pour calculer (27) le gain résiduel (142) dans la sous-bande à l'aide d'un deuxième rapport impliquant la première caractéristique relative à l'amplitude, la deuxième caractéristique relative à l'amplitude et le produit interne, le deuxième rapport étant différent du premier rapport, où la première caractéristique relative à l'amplitude et la deuxième caractéristique relative à l'amplitude sont déterminées à partir d'amplitudes, de puissances, d'énergies ou de toutes puissances d'amplitudes avec un exposant supérieur à 1, et

dans lequel le calculateur de paramètres (140) est configuré pour calculer le gain latéral (141) et le gain résiduel (142) de sorte que le gain résiduel (142) dépende du gain latéral (141), et dans lequel l'interface de sortie (160) est configurée pour effectuer une quantification conjointe à l'aide de groupes de points de quantification, chaque groupe de points de quantification étant défini par un rapport relatif à l'amplitude fixe entre le premier canal (101) et le deuxième canal (102).

**2.** Appareil selon la revendication 1,
dans lequel le calculateur de paramètres (140) est configuré pour calculer, pour chaque sous-bande d'une pluralité de sous-bandes de la représentation par sous-bande du premier canal (101) et du deuxième canal (102), le gain latéral (141) et le gain résiduel (142).

**3.** Appareil selon l'une des revendications précédentes,
dans lequel le calculateur de paramètres (140) est configuré pour calculer (26) le gain latéral (141) à l'aide d'une première fraction présentant un premier numérateur et un premier dénominateur, le premier numérateur impliquant la première caractéristique relative à l'amplitude du premier canal (101) et la deuxième caractéristique relative à l'amplitude du deuxième canal (102), et le premier dénominateur impliquant la première caractéristique relative à l'amplitude du premier canal (101) et la deuxième caractéristique relative à l'amplitude du deuxième canal (102) et le produit interne.

**4.** Appareil selon l'une des revendications précédentes,
dans lequel le calculateur de paramètres (140) est configuré pour calculer (27) le gain résiduel (142) à l'aide d'une deuxième fraction présentant un deuxième numérateur et un deuxième dénominateur, le deuxième numérateur impliquant le produit interne, et le deuxième dénominateur impliquant le produit interne.

**5.** Appareil selon la revendication 3 ou 4,

dans lequel le calculateur de paramètres (140) est configuré pour calculer (26) le gain latéral (141) à l'aide de la première fraction, dans lequel le premier numérateur comprend une différence entre la première caractéristique relative à l'amplitude du premier canal (101) et la deuxième caractéristique relative à l'amplitude du deuxième canal (102), et dans lequel le premier numérateur comprend une somme de la première caractéristique relative à l'amplitude du premier canal (101) et de la deuxième caractéristique relative à l'amplitude du deuxième canal (102) et d'une valeur dérivée du produit interne, ou
dans lequel le calculateur de paramètres (140) est configuré pour calculer (27) le gain résiduel (142) à l'aide de la deuxième fraction présentant le deuxième numérateur et le deuxième numérateur, dans lequel le deuxième numérateur comprend une différence entre une somme pondérée de la première caractéristique relative à l'amplitude du premier canal (101) et la deuxième caractéristique relative à l'amplitude du deuxième canal (102) et le produit interne, et dans lequel le deuxième dénominateur comprend la somme de la caractéristique relative à l'amplitude du premier canal (101), de la caractéristique relative à l'amplitude du deuxième canal (102) et d'une valeur dérivée du produit interne.

**6.** Appareil selon l'une des revendications précédentes,
dans lequel le calculateur de paramètres (140) est configuré pour calculer le gain latéral (141) pour une sous-bande et pour calculer le gain résiduel (142) pour la sous-bande (28) à l'aide du gain latéral (141) pour la sous-bande.

**7.** Appareil selon l'une des revendications précédentes,
dans lequel le calculateur de paramètres (140) est configuré pour calculer le gain latéral (141) de sorte que les valeurs du gain latéral (141) se situent dans une plage de $\pm$ 20% des valeurs déterminées sur base de l'équation suivante:

$$g_{t,b} = \frac{E_{L,t,b} - E_{R,t,b}}{E_{L,t,b} + E_{R,t,b} + 2X_{L/R,t,b}},$$

où t est un indice de trame, où b est un indice de sous-bande, où $E_l$ est une énergie du premier canal (101) dans la trame et la sous-bande, où $E_R$ est une énergie du deuxième canal (102) dans la trame et la sous-bande, où $E_R$ est une énergie du deuxième canal t et où X est une valeur absolue du produit interne entre le premier canal (101) et le deuxième canal (102) dans la trame t et la sous-bande b.

**8.** Appareil selon l'une des revendications précédentes,
dans lequel le calculateur de paramètres (140) est configuré pour calculer le gain résiduel (142) de sorte que les valeurs pour le gain résiduel (142) se situent dans une plage de $\pm$ 20% des valeurs déterminées sur base de l'équation suivante:

$$r_{t,b} = \left(\frac{(1-g_{t,b})E_{L,t,b}+(1+g_{t,b})E_{R,t,b}-2X_{L/R,t,b}}{E_{L,t,b}+E_{R,t,b}+2X_{L/R,t,b}}\right)^{1/2} \qquad ,$$

où t est un indice de trame, où b est un indice de sous-bande, où $E_l$ est une énergie du premier canal (101) dans la trame et la sous-bande, où $E_R$ est une énergie du deuxième canal (102) dans la trame t et la sous-bande b, et où X est une valeur absolue du produit interne entre le premier canal (101) et le deuxième canal (102) dans la trame t et la sous-bande b.

9.  Appareil selon l'une des revendications précédentes,

dans lequel le calculateur de paramètres (140) est configuré pour calculer une représentation par sous-bande du premier canal (101) et du deuxième canal (102) sous forme d'une séquence de spectres à valeurs complexes, dans lequel chaque spectre est relatif à une trame temporelle du premier canal (101) ou du deuxième canal (102), dans lequel les trames temporelles relatives à la séquence de spectres de valeurs complexes sont adjacentes dans la séquence de spectres de valeurs complexes et se chevauchent, ou
dans lequel le calculateur de paramètres (140) est configuré pour calculer la première caractéristique relative à l'amplitude du premier canal (101) et la deuxième caractéristique relative à l'amplitude du deuxième canal (102) en élevant au carré les amplitudes des valeurs spectrales complexes dans une sous-bande et en additionnant les amplitudes au carré dans la sous-bande, ou
dans lequel le calculateur de paramètres (140) est configuré pour calculer le produit interne en additionnant, dans la sous-bande, les produits, dans lequel chaque produit implique une valeur spectrale dans un bin de fréquences du premier canal (101) et une valeur spectrale complexe conjuguée du deuxième canal (102) pour le bin de fréquences, et en formant une amplitude d'un résultat de l'addition.

10. Appareil selon l'une des revendications précédentes,
    dans lequel le mélangeur vers le bas (120) est configuré pour calculer le signal de mélange vers le bas (122) à l'aide d'une compensation de phase absolue, dans lequel un canal présentant une énergie inférieure est uniquement tourné ou est tourné plus fortement qu'un canal présentant une énergie supérieure, lors du calcul du signal de mélange vers le bas (122).

11. Appareil selon la revendication 10,

dans lequel le mélangeur vers le bas (120) est configuré pour calculer (30) une différence de phase entre canaux, et
dans lequel le mélangeur vers le bas (120) est configuré pour calculer (32) un paramètre de rotation de phase absolue, et
dans lequel le mélangeur vers le bas (120) est configuré pour pondérer (34), lors du calcul du signal de mélange vers le bas (122), le premier canal (101) et le deuxième canal (102) à l'aide de la différence de phase entre canaux et du paramètre de rotation de phase absolue.

12. Appareil selon la revendication 10,
    dans lequel le mélangeur vers le bas (120) est configuré pour calculer (32) le paramètre de rotation de phase absolue sur base du gain latéral (141) déterminé par le calculateur de paramètres (140).

13. Appareil selon l'une des revendications 11 et 12,
    dans lequel le mélangeur vers le bas (120) est configuré pour calculer (30) la différence de phase entre canaux pour chaque sous-bande d'une trame, et dans lequel le mélangeur vers le bas (120) est configuré pour calculer (32) le paramètre de rotation de phase absolue pour chaque sous-bande de la trame.

14. Appareil selon l'une des revendications 10 à 13,
    dans lequel le mélangeur vers le bas (120) est configuré pour calculer le paramètre de rotation de phase absolue de sorte que le paramètre de rotation de phase absolue se situe dans une plage de $\pm$ 20% des valeurs déterminées par l'équation suivante:

$$\text{ß} = \text{atan2}\left(\sin(IPD_{t,b}), \cos(IPD_{t,b}) + A\frac{1+g_{t,b}}{1-g_{t,b}}\right) \qquad ,$$

où atan2 est la fonction atan2, où $\beta$ est le paramètre de rotation de phase absolue, où IPD est la différence de phase entre canaux, où t est un indice de trame, b est un indice de sous-bande, et $g_{t,b}$ est le gain latéral (141) pour la trame t et la sous-bande b, et où A est une valeur comprise entre 0,1 et 100 ou entre -0,1 et -100.

15. Appareil selon l'une des revendications 10 à 14,
dans lequel le mélangeur vers le bas (120) est configuré pour calculer (34) le signal de mélange vers le bas (122) de sorte que le signal de mélange vers le bas présente des valeurs comprises dans une plage de $\pm$ 20% des valeurs déterminées par l'équation suivante:

$$M_{t,k} = \frac{e^{-i\beta}L_{t,k} + e^{i(IPD_{t,b}-\beta)}R_{t,k}}{\sqrt{2}}$$

où $M_{t,k}$ est le signal de mélange vers le bas (122) pour la trame t et le bin de fréquences k, où $L_{t,k}$ est le premier canal (101) pour la trame t et le bin de fréquences k, où $\tilde{R}_{t,k}$ est le deuxième canal (102) pour la trame t et le bin de fréquences k, où $IPD_{t,k}$ est une différence de phase entre canaux pour la trame t et la sous-bande b comprenant le bin de fréquences k, et où $\beta$ est le paramètre de rotation de phase.

16. Appareil selon l'une des revendications précédentes,
dans lequel l'interface de sortie (160) comprend un codeur de forme d'onde configuré pour coder en forme d'onde le signal de mélange vers le bas (122) pour obtenir les informations sur le signal de mélange vers le bas (122).

17. Appareil selon la revendication 1, dans lequel le calculateur de paramètres (140) est configuré pour calculer le gain latéral (141) de sorte que le gain latéral (141) présente une plage de valeurs comprise entre -1 et +1, et
dans lequel l'interface de sortie (160) est configurée pour utiliser un code présentant un bit de signe et présentant des valeurs de gain latéral qui sont uniquement positives ou qui sont uniquement négatives.

18. Appareil selon l'une des revendications 1 ou 17,
dans lequel l'interface de sortie (160) est configurée:

pour calculer (50) une différence de niveau entre canaux entre le premier canal (101) et le deuxième canal (102),
pour identifier (52) le groupe de points de quantification correspondant à la différence de niveau entre canaux,
pour rechercher (54) uniquement dans le groupe identifié; et
pour combiner (56) un bit de signe, une identification du groupe et une identification du point dans le groupe identifié pour obtenir un mot de code représentant le gain latéral quantifié et le gain résiduel quantifié.

19. Appareil selon l'une des revendications 1, 17 ou 18,
dans lequel un livre de codes utilisé par l'interface de sortie (160) comprend un tableau de codes avec une multitude d'entrées, chaque entrée étant identifiée par un mot de code binaire, chaque mot de code binaire présentant un bit de signe, un premier groupe de bits identifiant le groupe de points de quantification, et un deuxième groupe de bits identifiant un point de quantification dans le groupe de points de quantification.

20. Appareil selon l'une des revendications 1, 17, 18 ou 19,
dans lequel un livre de codes utilisé par l'interface de sortie (160) comprend 16 groupes de points de quantification, 8 points de quantification par groupe, et dans lequel un mot de code du livre de codes est un mot de code de 8 bits avec un seul bit de signe (57a) et un groupe de 4 bits (57b) identifiant un groupe parmi les 16 groupes et un groupe de 3 bits (57c) identifiant un point de quantification dans un groupe identifié de points de quantification.

21. Appareil selon l'une des revendications précédentes,
dans lequel le calculateur de paramètres (140) est configuré:

pour calculer (60) le signal latéral à partir du premier canal (101) et du deuxième canal (102);
pour déterminer (61) une pluralité de gains résiduels à partir des différences entre le signal latéral et le signal de mélange vers le bas (122) pondérées par une pluralité de gains latéraux de test différents;
pour sélectionner (62) un gain latéral de test spécifique parmi la pluralité de gains latéraux de test différents comme gain latéral (141) pour lequel le signal résiduel remplit une condition prédéfinie; et
pour calculer (63) le gain résiduel (142) à partir d'un signal résiduel spécifique déterminé par le gain latéral de test spécifique.

**22.** Appareil selon la revendication 21,
dans lequel le gain résiduel (142) est déterminé à partir d'une énergie du signal résiduel spécifique et d'une énergie du signal de mélange vers le bas (122) ou d'une énergie d'une somme du premier canal (101) et du deuxième canal (102).

**23.** Appareil de décodage d'un signal multicanal codé (200), comprenant:

une interface d'entrée (204) destinée à recevoir le signal multicanal codé (200) et à obtenir un signal de mélange vers le bas (207), un gain latéral (206) et un gain résiduel (205) à partir du signal multicanal codé (200);
un synthétiseur de signal résiduel (208) destiné à synthétiser un signal résiduel (209) à l'aide du gain résiduel (205); et
un mélangeur vers le haut (212) destiné à mélanger vers le haut le signal de mélange vers le bas (207) à l'aide du gain latéral (206) et du signal résiduel (209) pour obtenir un premier canal reconstruit (213) et un deuxième canal reconstruit (214),
dans lequel le mélangeur vers le haut (212) est configuré

pour effectuer une première opération de pondération (70) du signal de mélange vers le bas (207) à l'aide du gain latéral (206) pour obtenir un premier signal de mélange vers le bas pondéré (76),
pour effectuer une deuxième opération de pondération (71) à l'aide du gain latéral (206) et du signal de mélange vers le bas (207) pour obtenir un deuxième signal de mélange vers le bas pondéré (77), dans lequel la première opération de pondération (70) est différente de la deuxième opération de pondération (71), de sorte que le premier signal de mélange vers le bas pondéré (76) soit différent du deuxième signal de mélange vers le bas pondéré (77), et
pour calculer le premier canal reconstruit (213) à l'aide d'une première combinaison (72) du premier signal de mélange vers le bas pondéré (76) et du signal résiduel (209) et pour calculer le deuxième canal reconstruit (214) à l'aide d'une deuxième combinaison (73) du deuxième signal de mélange vers le bas pondéré (77) et du signal résiduel (209),

dans lequel l'interface d'entrée (204) est configurée pour extraire les mots de code, dans lequel un mot de code comprend ensemble un gain latéral quantifié et un gain résiduel quantifié, et dans lequel l'interface d'entrée (204) est configurée pour dé-quantifier le mot de code conjoint à l'aide d'un livre de codes prédéfini pour obtenir le gain latéral (206) et le gain résiduel (205) utilisés par le synthétiseur de signal résiduel (208) et le mélangeur vers le haut (212).

**24.** Appareil selon la revendication 23,

dans lequel le mélangeur vers le haut (212) est configuré pour combiner le signal de mélange vers le bas pondéré (76) et le signal résiduel (209) à l'aide de la première combinaison (72) lors du calcul du premier canal reconstruit (213), et
dans lequel le mélangeur vers le haut (212) est configuré pour combiner le deuxième signal de mélange vers le bas pondéré (77) et le signal résiduel (209) à l'aide de la deuxième combinaison (73) lors du calcul du deuxième canal reconstruit (214), dans lequel la première règle de combinaison (72) et la deuxième règle de combinaison (73) sont différentes l'une de l'autre.

**25.** Appareil selon la revendication 24,
dans lequel l'une des première et deuxième combinaisons (72, 73) est une opération d'addition et l'autre des première et deuxième combinaisons (72, 73) est une opération de soustraction.

**26.** Appareil selon l'une des revendications 23 à 25,

dans lequel le mélangeur vers le haut (212) est configuré pour effectuer la première opération de pondération (70) comprenant un facteur de pondération dérivé d'une somme du gain latéral (206) et d'un premier nombre prédéterminé, et
dans lequel le mélangeur vers le haut (212) est configuré pour effectuer la deuxième opération de pondération (71) comprenant un facteur de pondération dérivé d'une différence entre un deuxième nombre prédéterminé et le gain latéral (206), dans lequel le premier nombre prédéterminé et le deuxième nombre prédéterminé sont identiques l'un à l'autre ou sont différents l'un de l'autre.

**27.** Appareil selon l'une des revendications 23 à 26,

dans lequel le synthétiseur de signal résiduel (208) est configuré pour pondérer le signal de mélange vers le bas (207) d'une trame précédente à l'aide du gain résiduel (205) pour une trame actuelle pour obtenir le signal résiduel (209) pour la trame actuelle, ou
pour pondérer (88) un signal décorrélé (80) dérivé de la trame actuelle ou d'une ou plusieurs trames précédentes à l'aide du gain résiduel (205) pour la trame actuelle pour obtenir le signal résiduel (209) pour la trame actuelle.

**28.** Appareil selon l'une des revendications 23 à 27,
dans lequel le synthétiseur de signal résiduel (208) est configuré pour calculer le signal résiduel (209) de sorte qu'une énergie du signal résiduel (209) soit égale à une énergie de signal indiquée par le gain résiduel (205).

**29.** Appareil selon l'une des revendications 23 à 28,
dans lequel le synthétiseur de signal résiduel (208) est configuré pour calculer le signal résiduel (209) de sorte que les valeurs du signal résiduel (209) se situent dans une plage de $\pm$ 20 % des valeurs déterminées sur base de l'équation suivante:

$$res_{t,k} = \frac{\tilde{r}_{t,b} g_{norm} \tilde{\rho}_{t,k}}{\sqrt{2}},$$

où $res_{t,k}$ est le signal résiduel (209) pour la trame t et le bin de fréquences k, où $\tilde{r}_{t,b}$ est le gain résiduel (205) pour la trame t et la sous-bande b comprenant le bin de fréquences k, et où $\tilde{\rho}_{t,k}$ est un signal brut pour le signal résiduel (209), et où $g_{norm}$ est un facteur de réglage d'énergie qui peut être présent ou non.

**30.** Appareil selon l'une des revendications 23 à 29,

où $g_{norm}$ est un facteur de réglage d'énergie présentant des valeurs situées dans la plage de $\pm$ 20% des valeurs déterminées par l'équation suivante:

$$\sqrt{\frac{E_{\tilde{M},t,b}}{E_{\tilde{\rho},t,b}}},$$

où $E_{\tilde{M},t,b}$ est l'énergie du signal de mélange vers le bas (207) pour la trame t et la sous-bande b, et où $E_{\tilde{\rho},t,b}$ est l'énergie du signal résiduel (209) pour la sous-bande b et la trame t, ou
dans lequel un signal brut pour le signal résiduel (209) est déterminé sur base de l'équation suivante:

$$\tilde{\rho}_{t,k} = \tilde{M}_{t-d_b,k},$$

où $\tilde{\rho}_{t,k}$ est le signal brut pour le signal résiduel (209),
où $\tilde{M}_{t-d_b,k}$ est le signal de mélange vers le bas (207) pour la trame $t$ - $t_b$ et le bin de fréquences k,
où $d_b$ est un retard de trame supérieur à 0, ou
dans lequel le mélangeur vers le haut (212) est configuré pour calculer le premier canal reconstruit (213) et le deuxième canal reconstruit (214) de sorte que le premier canal reconstruit (213) et le deuxième canal reconstruit (214) présentent des valeurs qui se situent dans la plage de $\pm$ 20% par rapport aux valeurs déterminées par les équations suivantes:

$$\tilde{L}_{t,k} = \frac{(\tilde{M}_{t,k}(1+\tilde{g}_{t,b}) + \tilde{r}_{t,b} g_{norm} \tilde{\rho}_{t,k})}{\sqrt{2}}$$

$$\tilde{R}_{t,k} = \frac{(\tilde{M}_{t,k}(1-\tilde{g}_{t,b}) - \tilde{r}_{t,b} g_{norm} \tilde{\rho}_{t,k})}{\sqrt{2}}$$

où $\tilde{M}_{t,k}$ est le signal de mélange vers le bas (207) pour la trame t et le bin de fréquences k, où $\tilde{L}_{t,k}$ est le premier canal reconstruit (213) pour la trame t et le bin de fréquences k, où $\tilde{R}_{t,k}$ est le deuxième canal reconstruit (214) pour la trame t et le bin de fréquences k, où $\tilde{g}_{t,b}$ est le gain latéral (206) pour la trame t et la sous-bande b, où $\tilde{r}_{t,b}$ est le gain résiduel (205) pour la trame t et la sous-bande b, où $g_{norm}$ est un facteur de réglage d'énergie qui peut être présent ou non, et où $\tilde{\rho}_{t,k}$ est le signal brut pour le signal résiduel (209) pour la trame t et le bin de fréquences k.

31. Appareil selon l'une des revendications 23 à 30,

dans lequel l'interface d'entrée (204) est configurée pour obtenir, à partir du signal multicanal codé (200), les valeurs de différence de phase entre canaux, et

dans lequel le synthétiseur de signal résiduel (208) ou le mélangeur vers le haut (212) est configuré pour appliquer les valeurs de différence de phase entre canaux lors du calcul du signal résiduel ou du premier canal reconstruit (213) et du deuxième canal reconstruit (214).

32. Appareil selon la revendication 31,

dans lequel le mélangeur vers le haut (212) est configuré pour calculer un paramètre de rotation de phase absolue à partir d'une valeur de différence de phase entre canaux IPD, et

pour appliquer le paramètre de rotation de phase absolue lors du calcul du premier canal reconstruit (213) d'une première manière et pour appliquer la valeur de différence de phase entre canaux et/ou le paramètre de rotation de phase absolue lors du calcul du deuxième canal reconstruit (214) d'une deuxième manière, la première manière étant différente de la deuxième manière.

33. Appareil selon la revendication 32,
dans lequel le mélangeur vers le haut (212) est configuré pour calculer le paramètre de rotation de phase absolue de sorte que le paramètre de rotation de phase absolue se situe dans les limites de ± 20 % des valeurs déterminées par l'équation suivante:

$$ß = \operatorname{atan2}(\sin(IPD_{t,b}), \cos(IPD_{t,b}) + A\frac{1+g_{t,b}}{1-g_{t,b}})$$,

où atan2 est la fonction atan2, où β est le paramètre de rotation de phase absolue, où IPD est la différence de phase entre canaux, où t est un indice de trame, b est un indice de sous-bande et $\tilde{g}_{t,b}$ est le gain latéral (206) pour la trame t et la sous-bande b, et où A est une valeur comprise entre 0,1 et 100 ou entre -0,1 et -100.

34. Appareil selon la revendication 23,
dans lequel un livre de codes utilisé par l'interface d'entrée (204) comprend 16 groupes de points de quantification, 8 points de quantification par groupe, et dans lequel un mot de code du livre de codes est un mot de code de 8 bits avec un seul bit de signe (57a) et un groupe de 4 bits (57b) identifiant un groupe parmi les 16 groupes et un groupe de 3 bits (57c) identifiant un point de quantification dans un groupe identifié de points de quantification.

35. Appareil selon l'une des revendications 23 à 34,

dans lequel le mélangeur vers le haut (212) est configuré pour calculer le premier canal reconstruit (213) et le deuxième canal reconstruit (214) dans un domaine spectral,
dans lequel l'appareil comprend par ailleurs un convertisseur spectre-temps (216) destiné à convertir le premier canal reconstruit (213) et le deuxième canal reconstruit (214) à un domaine temporel.

36. Appareil selon la revendication 28,

dans lequel le convertisseur spectre-temps (216) est configuré pour (301) convertir, pour chacun du premier canal reconstruit (213) et du deuxième canal reconstruit (214), les trames suivantes en une séquence temporelle de trames,
pour pondérer (1312) chaque trame temporelle à l'aide d'une fenêtre de synthèse; et
pour effectuer une opération de chevauchement et d'addition (1314) des trames temporelles divisées en fenêtres suivantes pour obtenir un bloc temporel du premier canal reconstruit (213) et un bloc temporel du deuxième canal reconstruit (214).

**37.** Procédé de codage d'un signal multicanal (100) comprenant au moins deux canaux (101, 102), comprenant le fait de:

calculer (120) un signal de mélange vers le bas (122) à partir du signal multicanal (100);

calculer (140) un gain latéral (141) à partir d'un premier canal (101) des au moins deux canaux (101, 102) et d'un deuxième canal (102) des au moins deux canaux (101, 102) et calculer un résidu gain (142) à partir du premier canal (101) et du deuxième canal (102); et

générer (160) un signal de sortie, le signal de sortie comprenant les informations sur le signal de mélange vers le bas (122) et sur le gain latéral (141) et le gain résiduel (142),

dans lequel le calcul (140) comprend le fait de générer (21) une représentation par sous-bande du premier canal et du deuxième canal, calculer (21, 22, 23, 24) une première caractéristique relative à l'amplitude du premier canal dans une sous-bande et calculer une deuxième caractéristique relative à l'amplitude du deuxième canal dans la sous-bande, calculer (25) un produit interne du premier canal et du deuxième canal dans la sous-bande; calculer (26) le gain latéral dans la sous-bande à l'aide d'un premier rapport impliquant la première caractéristique relative à l'amplitude, la deuxième caractéristique relative à l'amplitude et le produit interne; et calculer (27) le gain résiduel (142) dans la sous-bande à l'aide d'un deuxième rapport impliquant la première caractéristique relative à l'amplitude, la deuxième caractéristique relative à l'amplitude et le produit interne, le deuxième rapport étant différent du premier rapport, dans lequel la première caractéristique relative à l'amplitude et la deuxième caractéristique relative à l'amplitude sont déterminées à partir d'amplitudes, de puissances, d'énergies ou de toutes puissances d'amplitudes avec un exposant supérieur à 1,

dans lequel le calcul (140) comprend le fait de calculer le gain latéral (141) et le gain résiduel (142) de sorte que le gain résiduel (142) dépend du gain latéral (141), et dans lequel la génération (160) comprend le fait d'effectuer une quantification conjointe à l'aide de groupes de points de quantification, chaque groupe de points de quantification étant défini par un rapport relatif à l'amplitude fixe entre le premier canal (101) et le deuxième canal (102).

**38.** Procédé de décodage d'un signal multicanal codé (200), comprenant le fait de:

recevoir (204) le signal multicanal codé (200) pour obtenir un signal de mélange vers le bas (207), un gain latéral (206) et un gain résiduel (205) à partir du signal multicanal codé (200);

synthétiser (208) un signal résiduel (209) à l'aide du gain résiduel (205); et

mélanger vers le haut (212) le signal de mélange vers le bas (207) à l'aide du gain latéral (206) et du signal résiduel (209) pour obtenir un premier canal reconstruit (213) et un deuxième canal reconstruit (214),

dans lequel le mélange vers le haut (212) comprend le fait d'effectuer une première opération de pondération (70) du signal de mélange vers le bas (207) à l'aide du gain latéral (206) pour obtenir un premier signal de mélange vers le bas pondéré (76), d'effectuer une deuxième opération de pondération (71) à l'aide du gain latéral (206) et du signal de mélange vers le bas (207) pour obtenir un deuxième signal de mélange vers le bas pondéré (77), dans lequel la première opération de pondération (70) est différente de la deuxième opération de pondération (71), de sorte que le premier signal de mélange vers le bas pondéré (76) soit différent du deuxième signal de mélange vers le bas pondéré (77), et calculer le premier canal reconstruit (213) à l'aide d'une combinaison (72) du premier signal de mélange vers le bas pondéré (76) et du signal résiduel (209), et calculer le deuxième canal reconstruit (214) à l'aide d'une deuxième combinaison (73) du deuxième signal de mélange vers le bas pondéré (77) et du signal résiduel (209),

dans lequel la réception (204) comprend le fait d'extraire les mots de code, dans lequel un mot de code comprend de manière conjointe un gain latéral quantifié et un gain résiduel quantifié, et dans lequel la réception (204) comprend le fait de dé-quantifier le mot de code conjoint à l'aide d'un livre de codes prédéfini pour obtenir le gain latéral (206) et le gain résiduel (205) utilisés par la synthèse (208) et le mélange vers le haut (212).

**39.** Programme d'ordinateur pour réaliser, lorsqu'il est exécuté sur l'ordinateur ou un processeur, le procédé selon la revendication 37 ou le procédé selon la revendication 38.

**40.** Signal multicanal codé (200) comprenant:

les informations sur un signal de mélange vers le bas (207), et

les mots de code, où un mot de code comprend de manière conjointe un gain latéral quantifié (206) et un gain résiduel quantifié (205),

dans lequel le gain latéral (206) dans une sous-bande représente un premier rapport impliquant une première caractéristique relative à l'amplitude, une deuxième caractéristique relative à l'amplitude et un produit interne;

dans lequel le gain résiduel (205) dans la sous-bande représente un deuxième rapport impliquant la première caractéristique relative à l'amplitude, la deuxième caractéristique relative à l'amplitude et le produit interne, le deuxième rapport étant différent du premier rapport, dans lequel la première caractéristique relative à l'amplitude et la deuxième caractéristique relative à l'amplitude sont déterminées à partir d'amplitudes, de puissances, d'énergies ou de toutes puissances d'amplitudes avec un exposant supérieur à 1.

Fig. 1

Fig. 2

Fig. 3

Fig. 4

Fig. 5a

EP 3 539 125 B1

Fig. 5b

Fig. 6

Fig. 7

Fig. 8

EP 3 539 125 B1

Fig. 9

l(t), r(t)

F(1)  F(3)
F(2)  F(4)

overlapping frames

t

**Fig. 10a**

l(t)
r(t)

→ | analysis window | 1300

→ | DFT or DCT / MDCT with imaginary part estimated | 1302

→ L(t, k)
R(t, k)

t: frame index
k: spectrum index

**Fig. 10b**

Fig. 10c

213, 214 → **backward transformer** (1310) → **synthesis windower** (1312) → **overlap/ adder** (1314) → 217, 218 time domain channels

Fig. 10d

EP 3 539 125 B1

Fig. 11

Fig. 12

Fig. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006190247 A1
- EP 3067889 A1
- US 8036904 B2
- WO 2019020757 A2

**Non-patent literature cited in the description**

- FROM JOINT STEREO TO SPATIAL AUDIO COD-ING - RECENT PROGRESS AND STANDARDIZA-TION. *Proc. of the 7th Int. Conference on digital Audio Effects (DAFX-04), Naples, Italy,* 05 October 2004